# EUROPEAN PATENT APPLICATION

(11) **EP 4 742 247 A1**
(43) Date of publication of application: **13.05.2026**
(21) Application number: 25215329.1
(22) Date of filing: 12.11.2025
(51) Int. Cl.: G11C 16/04, G11C 11/22, G11C 13/00

(54) **MEMORY ARCHITECTURES WITH AMBIPOLAR SEMICONDUCTOR CHANNELS**

(30) Priority: 12.11.2024 US 202463719503 P; 29.10.2025 US 202519373387
(71) Applicant: MICRON TECHNOLOGY, INC., Boise, ID 83716-9632 (US)
(72) Inventor: FANTINI, Paolo, Boise, 83716-9632 (US); TORTORELLI, Innocenzo, Boise, 83716-9632 (US); PIROVANO, Agostino, Boise, 83716-9632 (US); FARRONATO, Matteo, Boise, 83716-9632 (US); IELMINI, Daniele, Boise, 83716-9632 (US)
(74) Representative: Marks & Clerk LLP

(57) **Abstract**

Methods, systems, and devices for memory architectures with ambipolar semiconductor channels are described. A memory device may include multiple conductors that are each associated with a respective activation line of a memory array, and a pillar that extends through the conductors. The pillar may include a semiconductor material extending along a length of the pillar and associated with an ambipolar channel along the length of the pillar. The memory device may also include multiple storage portions each including one or more storage materials (e.g., to store a charge, a dipole polarization, or a combination thereof). Each storage portion may be associated with a respective memory cell of the memory array and may be positioned between a respective one of the conductors and a respective portion of the semiconductor material along the length of the pillar.

## Description

### TECHNICAL FIELD

The following relates to one or more systems for memory, including memory architectures with ambipolar semiconductor channels.

### BACKGROUND

Memory devices are widely used to store information in various electronic devices such as computers, user devices, wireless communication devices, cameras, digital displays, and the like. Information is stored by programming memory cells within a memory device to various states. For example, binary memory cells may be programmed to one of two supported states, often corresponding to a logic 1 or a logic 0. In some examples, a single memory cell may support more than two possible states, any one of which may be stored by the memory cell. To access information stored by a memory device, a component may read (e.g., sense, detect, retrieve, identify, determine, evaluate) the state of one or more memory cells within the memory device. To store information, a component may write (e.g., program, set, assign) one or more memory cells within the memory device to corresponding states.

Various types of memory devices exist, including magnetic hard disks, random access memory (RAM), read-only memory (ROM), dynamic RAM (DRAM), synchronous dynamic RAM (SDRAM), static RAM (SRAM), ferroelectric RAM (FeRAM), magnetic RAM (MRAM), resistive RAM (RRAM), flash memory, phase change memory (PCM), 3-dimensional cross-point memory (3D cross point), not-or (NOR) and not-and (NAND) memory devices, and others. Memory devices may be described in terms of volatile configurations or non-volatile configurations. Volatile memory cells (e.g., DRAM) may lose their programmed states over time unless they are periodically refreshed by an external power source. Non-volatile memory cells (e.g., NAND) may maintain their programmed states for extended periods of time even in the absence of an external power source.

### BRIEF DESCRIPTION OF THE DRAWINGS

FIG. 1 shows an example of a memory system that supports memory architectures with ambipolar semiconductor channels in accordance with examples as disclosed herein.
FIG. 2 shows an example of a memory architecture that supports memory architectures with ambipolar semiconductor channels in accordance with examples as disclosed herein.
FIG. 3 shows an example of an architecture that supports memory architectures with ambipolar semiconductor channels in accordance with examples as disclosed herein.
FIGs. 4A and 4B show examples of operations on an architecture that supports memory architectures with ambipolar semiconductor channels in accordance with examples as disclosed herein.
FIG. 5 shows a block diagram of a memory device that supports memory architectures with ambipolar semiconductor channels in accordance with examples as disclosed herein.
FIG. 6 shows a flowchart illustrating a method or methods that support memory architectures with ambipolar semiconductor channels in accordance with examples as disclosed herein.

### DETAILED DESCRIPTION

Some memory systems may be expected to support data-intensive applications, such as artificial intelligence (AI) applications and other processes associated with a relatively large quantity of access operations. Such applications may be associated with relatively high-speed data access and may utilize substantial portions of a memory device. However, some memory devices (e.g., dynamic random access memory (DRAM), central processing unit (CPU) memory) may be constrained with relatively limited storage capacity and bandwidth capabilities, which may be inadequate for handling extensive data volumes. Further, other memory devices (e.g., solid state drive (SSD) memory devices, hard disk drive (HDD) memory devices) may support relatively higher storage capacity but may be associated with relatively high latency, which may impede performance in applications associated with increased data processing speeds. In some cases, capacity enhancements by reducing component size or pitch (e.g., along one or more dimensions of a memory array) may be limited (e.g., may become unfeasible or otherwise ineffective) based on practical and physical limitations of such techniques.

In accordance with one or more techniques described herein, a memory system (e.g., a not-and (NAND) memory system, a ferroelectric NAND (FeNAND) system) may support an architecture that includes ambipolar channels (e.g., ambipolar semiconductor channels, pillar channels) of a semiconductor material, such as a transition metal dichalcogenide (TMD). The ambipolar feature of such a channel may refer to a capability of a material to support the generation (e.g., mobilization, conduction) of both electrons (e.g., negative charge, charge reduction, increase of electrons) and holes (e.g., positive charge, charge increase, reduction of electrons) at a same or relatively similar rate (e.g., an ability for the material to behave as both an n-type semiconductor and a p-type semiconductor). In some examples, the use of such semiconductor materials may enable a relatively efficient generation of electrons and holes, which may support faster or lower-power read operations, or faster or lower-power write operations (e.g., faster switching between electron and hole generation, faster charge mobility, faster changes to a stored electric field), or both using respective portions of one or more storage materials of memory cells associated with (e.g., formed along the length of) the ambipolar channel. For example, such storage materials may store an electric field corresponding to a logic state of a memory cell, and such storage materials may include a charge-trapping material operable to store an electric field by moving charge (e.g., electrons) into or out of the charge-trapping material, or a polarization material (e.g., a ferroelectric material, a dipole material) operable to store an electric field by storing a polarization (e.g., a dipole polarization, a dipole orientation, an electric field polarization, an electric field orientation) by applying a coercive electric field across the polarization material, or a combination thereof. In some examples, storage material(s) may include a ferroelectric layer (e.g., in contact with the semiconductor material), which may complement the ambipolar capability of the semiconductor material (e.g., a faster switching between electron and hole generation, supporting positive and negative electric field orientations) in the context of memory operations. Such techniques may enable a memory system to support next-generation applications, such as AI applications and other data-intensive processes. For example, by implementing an ambipolar pillar channel, a memory system may support more efficient access operations (e.g., write-in-place algorithms), which may mitigate processing overhead by reducing memory management operations (e.g., garbage collection) and may reduce write amplification effects. Thus, memory systems may be configured to support higher capacity, reduced latency, increased lifespan, reduced power consumption, and other benefits.

In addition to applicability in memory systems as described herein, techniques for memory architectures with ambipolar semiconductor channels may be generally implemented to improve the performance of various electronic devices and systems (including AI applications, augmented reality (AR) applications, virtual reality (VR) applications, and gaming). Some electronic device applications, including high-performance applications such as AI, AR, VR, and gaming, may be associated with relatively high processing requirements to satisfy user expectations. As such, increasing processing capabilities of the electronic devices by decreasing response times, improving power consumption, reducing complexity, increasing data throughput or access speeds, decreasing communication times, or increasing memory capacity or density, among other performance indicators, may improve user experience or appeal. Implementing the techniques described herein may improve the performance of electronic devices by improving memory access speeds (e.g., by support write-in-place access operations) and supporting increased capacity, which may decrease processing or latency times, improve response times, and otherwise improve user experience, among other benefits.

Features of the disclosure are illustrated and described in the context of systems, devices, and circuits. Features of the disclosure are further illustrated and described in the context of memory architectures and flowcharts.

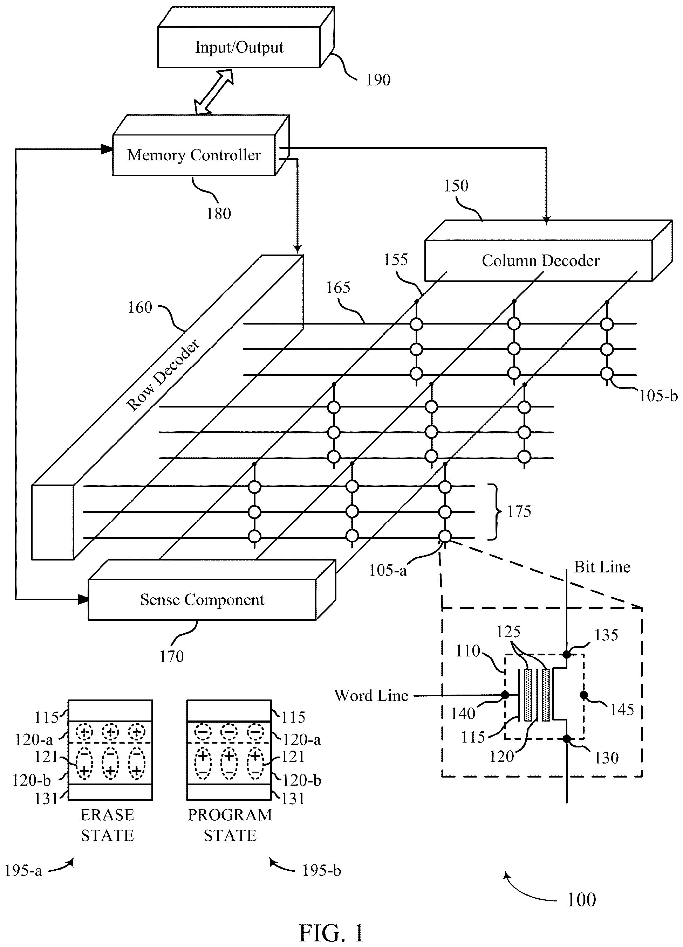

**FIG. 1** shows an example of a memory system 100 (e.g., a memory device) that supports memory architectures with ambipolar semiconductor channels in accordance with examples as disclosed herein. FIG. 1 is an illustrative representation of various components and features of the memory system 100. As such, the components and features of the memory system 100 are shown to illustrate functional interrelationships, and not necessarily physical positions within the memory system 100. Further, although some elements included in FIG. 1 are labeled with a numeric indicator, some other corresponding elements are not labeled, even though they are the same or would be understood to be similar, in an effort to increase visibility and clarity of the depicted features.

The memory system 100 may include one or more memory cells 105, such as memory cell 105-a and memory cell 105-b. In some examples, a memory cell 105 may be a NAND memory cell, such as in the blow-up diagram of memory cell 105-a. Each memory cell 105 may be programmed to store a logic value representing one or more bits of information. In some examples, a single memory cell 105-such as a memory cell 105 configured as a single-level cell (SLC)-may be programmed to one of two supported states and thus may store one bit of information at a time (e.g., a logic 0 or a logic 1). In some other examples, a single memory cell 105-such a memory cell 105 configured as a multi-level cell (MLC), a tri-level cell (TLC), a quad-level cell (QLC), or other type of multiple-level memory cell 105-may be programmed to one state of more than two supported states and thus may store more than one bit of information at a time. In some cases, a multiple-level memory cell 105 (e.g., an MLC memory cell, a TLC memory cell, a QLC memory cell) may be physically different than an SLC cell. For example, a multiple-level memory cell 105 may use a different cell geometry or may be fabricated using different materials. In some examples, a multiple-level memory cell 105 may be physically the same or similar to an SLC cell, and other circuitry in a memory block (e.g., a controller, sense amplifiers, drivers) may be configured to operate (e.g., read and program) the memory cell as an SLC cell, or as an MLC cell, or as a TLC cell, etc.

In some NAND memory arrays, each memory cell 105 may be illustrated as a transistor that includes a material portion (e.g., a floating gate, a replacement gate, a dielectric material, a charge-trapping material, a ferroelectric material) configured for storing an electric field representative of a logic value. For example, the blow-up in FIG. 1 illustrates a NAND memory cell 105-a that includes a transistor 110 (e.g., a metal-oxide-semiconductor (MOS) transistor) that may be used to store a logic value. The transistor 110 may include a control gate 115 and a storage portion 120. In some examples, a storage portion 120 may be between a dielectric material 125 (e.g., a gate dielectric) and a semiconductor channel (e.g., in contact with the semiconductor channel), or may be between two portions of dielectric material 125 (e.g., as illustrated), among other implementations. A storage portion 120 may include a charge-trapping storage portion 120-a (e.g., a charge-trapping material), or a ferroelectric storage portion 120-b (e.g., a ferroelectric material, including ferroelectric dipoles 121), or a combination of a charge-trapping storage portion 120-a and a ferroelectric storage portion 120-b, among other implementations that are configured to store an electric field (e.g., between the control gate 115 and a semiconductor channel). A transistor 110 also may include a first node 130 (e.g., a source or drain) and a second node 135 (e.g., a drain or source), and a semiconductor channel (e.g., of the memory cell 105, of a string or memory cells 105) may be coupled between the first node 130 and the second node 135.

A logic value may be stored in a memory cell 105 (e.g., in a transistor 110) by storing (e.g., writing, inducing) an electric field to a storage portion 120 of the memory cell 105. For example, a memory cell 105 may be written with a cell state 195 (e.g., an electric field state, a charge state, a polarization state, a written state, corresponding to a logic state), such as either a cell state 195-a (e.g., an "ERASE" state) or a cell state 195-b (e.g., a "PROGRAM" state). Although the example of cell states 195-a and 195-b illustrate an example that may support two logic states (e.g., for an SLC implementation), the described techniques may be implemented to support more than two cell states 195 (e.g., more than two logic states, for a multiple-level cell implementation), which may be further based on different stored electric field magnitudes (e.g., in combination with electric field polarizations, such as positive or negative electric fields), among other implementations.

An electric field stored at a storage portion 120 may affect the threshold voltage of a transistor 110, thereby affecting the amount of current that flows through the transistor 110 (e.g., through a channel portion 131, corresponding to a semiconductor channel between a first node 130 and a second node 135) when the transistor 110 is activated (e.g., when a voltage is applied to the control gate 115, when the memory cell 105-a is read). For example, the cell state 195-a may be associated with supporting a relatively lower voltage at a gate 115 to activate a channel portion 131 (e.g., a relatively lower activation voltage, a relatively lower VT, a relatively higher conductivity through the channel portion 131 for a given voltage at the gate 115), whereas the cell state 195-b may be associated with supporting a relatively higher voltage at a gate 115 to activate a channel portion 131 (e.g., a relatively higher activation voltage, a relatively higher VT a relatively lower conductivity through the channel portion 131 for the given voltage at the gate 115).

In some examples, writing an electric field to a memory cell 105 may involve moving charge (e.g., electrons) into or out of a storage portion 120 (e.g., a charge-trapping storage portion 120-a), and different stored charge may correspond to different logic states. For example, an electric field associated with the cell state 195-a may include a net positive charge (e.g., as stored in a charge-trapping storage portion 120-a, as a result of transferring electrons from a storage portion 120, as a result of hole injection), and an electric field associated with the cell state 195-b may include a net negative charge (e.g., as stored in a charge-trapping storage portion 120-a, as a result of transferring electrons into the storage portion 120, as a result of electron injection).

In some examples, writing an electric field to a memory cell 105 may involve storing a polarization (e.g., a dipole polarization, a polarization orientation, a dipole orientation, a local electric field orientation) in a storage portion 120 (e.g., a ferroelectric storage portion 120-b), and different polarizations may correspond to different logic states. For example, an electric field associated with the cell state 195-a may correspond to a first polarization of a ferroelectric storage portion 120-b (e.g., a first orientation of dipoles 121, corresponding to a positive local electric field from a gate 115 to a channel portion 131), and an electric field associated with a cell state 195-b may correspond to a second polarization of a ferroelectric storage portion 120-b (e.g., a second orientation of dipoles 121, corresponding to a negative local electric field from a gate 115 to a channel portion 131). Various implementations of the described techniques may involve writing an electric field based on moving charge into or out of a storage portion 120, or storing a polarization in a storage portion 120, or a combination thereof.

A logic value stored in the transistor 110 may be sensed (e.g., as part of a read operation) by applying a voltage to the control gate 115 (e.g., to control node 140, via a word line 165) to activate the transistor 110 and measuring (e.g., detecting, sensing) an amount of current that flows through the first node 130 or the second node 135 (e.g., through a channel portion 131, via a bit line 155). For example, a sense component 170 may determine whether an SLC memory cell 105 stores a logic 0 or a logic 1 in a binary manner (e.g., based on a presence or absence of a current through the memory cell 105 when a read voltage is applied to the control gate 115, based on whether the current is above or below a threshold current). For a multiple-level memory cell 105, a sense component 170 may determine a logic value stored in the memory cell 105 based on various intermediate threshold levels of current when a read voltage is applied to the control gate 115, or by applying different read voltages to the control gate and evaluating different resulting levels of current through the transistor 110, or various combinations thereof. In one example of a multiple-level architecture, a sense component 170 may determine the logic value of a TLC memory cell 105 based on eight different levels of current, or ranges of current, that define the eight potential logic values that could be stored by the TLC memory cell 105.

An SLC memory cell 105 may be written by applying one of two voltages (e.g., a voltage above a threshold or a voltage below a threshold) to the memory cell 105 to store an electric field on the storage portion 120 and thereby cause the memory cell 105 to store one of two possible logic values. For example, when a first voltage is applied to the control node 140 (e.g., via a word line 165, to write a "PROGRAM" state) relative to a bulk node 145 (e.g., a body node) or channel portion 131 for the transistor 110 (e.g., a voltage across the storage portion 120), electrons may tunnel into the storage portion 120 (e.g., into a charge-trapping storage portion 120-a), or dipoles 121 (e.g., of a ferroelectric storage portion 120-b) may orient with a negative field along a direction from the control gate 115 to the channel portion 131, or both. Such operations may be referred to as programming the memory cell 105 and may occur as part of a write operation. A programmed memory cell may, in some cases, be considered as storing a logic 0. When a second voltage is applied to the control node 140 (e.g., to write an "ERASE" state) relative to the bulk node 145 or channel portion 131 for the transistor 110, electrons may leave the storage portion 120 (e.g., out of a charge-trapping storage portion 120-a), or dipoles 121 (e.g., of a ferroelectric storage portion 120-b) may orient with a positive field from the control gate 115 to the channel portion 131, or both. Such operations may be referred to as erasing the memory cell 105 and may occur as part of an erase operation. An erased memory cell may, in some cases, be considered as storing a logic 1.

In contrast to writing an SLC memory cell 105, writing a multiple-level (e.g., MLC, TLC, or QLC) memory cell 105 may involve applying different electric fields to the memory cell 105 (e.g., to the control node 140 or bulk node 145 thereof) at a finer level of granularity to more finely control the amount of electric field stored at the storage portion 120, thereby enabling a larger set of logic values to be represented. Thus, multiple-level memory cells 105 may provide greater density of storage relative to SLC memory cells 105 but may, in some cases, involve narrower read or write margins or greater complexities for supporting circuitry.

In some examples, each page of memory cells 105 may be connected to a corresponding word line 165, and each column of memory cells 105 may be connected to a corresponding bit line 155 (e.g., digit line). Thus, one memory cell 105 may be located at the intersection of a word line 165 and a bit line 155. This intersection may be referred to as an address of a memory cell 105. In some cases, word lines 165 and bit lines 155 may be substantially perpendicular to one another, and may be generically referred to as access lines or select lines.

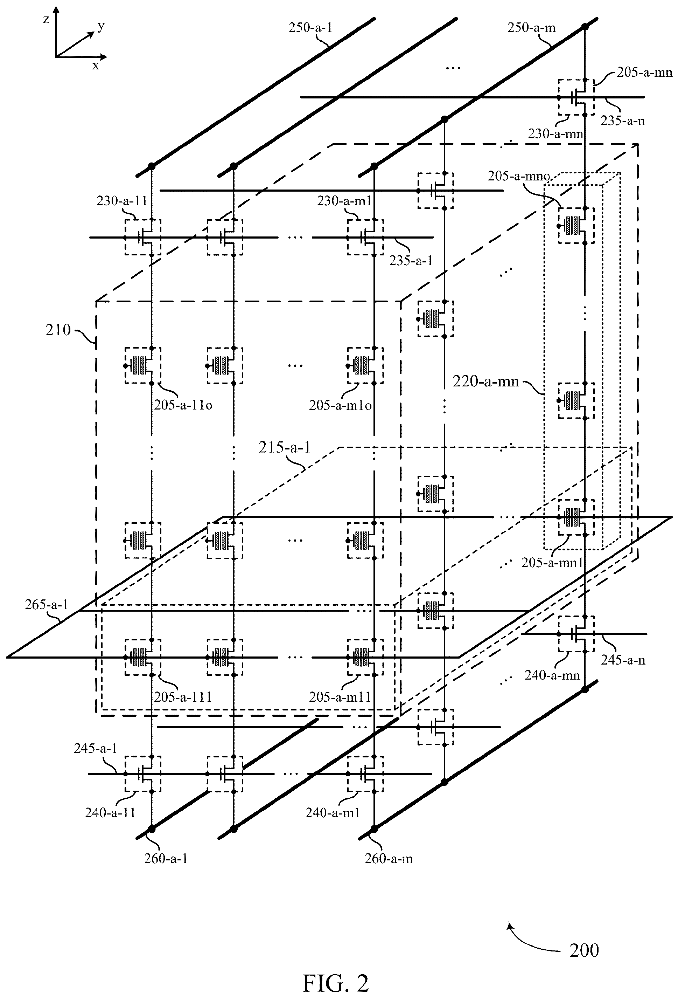

In some cases, a memory system 100 may include a three-dimensional (3D) memory array, where multiple two-dimensional (2D) memory arrays may be formed on top of one another. In some examples, such an arrangement may increase the quantity of memory cells 105 that may be fabricated on a single die or substrate as compared with 1D arrays, which, in turn, may reduce production costs, or increase the performance of the memory array, or both. In the example of FIG. 1, memory system 100 includes multiple levels (e.g., decks, layers, planes, tiers) of memory cells 105. The levels may, in some examples, be separated by an electrically insulating material. Each level may be aligned or positioned so that memory cells 105 may be aligned (e.g., exactly aligned, overlapping, or approximately aligned) with one another across each level, forming a memory cell stack 175. In some cases, memory cells aligned along a memory cell stack 175 may be referred to as a string of memory cells 105 (e.g., as described with reference to FIG. 2).

Accessing memory cells 105 may be controlled through a row decoder 160 and a column decoder 150. For example, the row decoder 160 may receive a row address from the memory controller 180 and activate an appropriate word line 165 based on the received row address. Similarly, the column decoder 150 may receive a column address from the memory controller 180 and activate an appropriate bit line 155. Thus, by activating one word line 165 and one bit line 155, one memory cell 105 may be accessed. As part of such accessing, a memory cell 105 may be read (e.g., sensed) by sense component 170. For example, the sense component 170 may be configured to determine the stored logic value of a memory cell 105 based on a signal generated by accessing the memory cell 105. The signal may include a current, a voltage, or both a current and a voltage on the bit line 155 for the memory cell 105 and may depend on the logic value stored by the memory cell 105. The sense component 170 may include various circuitry (e.g., transistors, amplifiers) configured to detect and amplify a signal (e.g., a current or voltage) on a bit line 155. The logic value of memory cell 105 as detected by the sense component 170 may be output via input/output component 190. In some cases, a sense component 170 may be a part of a column decoder 150 or a row decoder 160, or a sense component 170 may otherwise be connected to or in electronic communication with a column decoder 150 or a row decoder 160.

A memory cell 105 may be programmed or written by activating the relevant word line 165 and bit line 155 to enable a logic value (e.g., representing one or more bits of information) to be stored in the memory cell 105. A column decoder 150 or a row decoder 160 may accept data (e.g., from the input/output component 190) to be written to the memory cells 105. In the case of NAND memory, a memory cell 105 may be written by storing electrons in a charge-trapping structure or an insulating layer.

A memory controller 180 may control the operation (e.g., read, write, re-write, refresh) of memory cells 105 through the various components (e.g., row decoder 160, column decoder 150, sense component 170). In some cases, one or more of a row decoder 160, a column decoder 150, and a sense component 170 may be co-located with a memory controller 180. A memory controller 180 may generate row and column address signals in order to activate a desired word line 165 and bit line 155. In some examples, a memory controller 180 may generate and control various voltages or currents used during the operation of memory system 100.

Some memory systems may be expected to support data-intensive applications, such as artificial intelligence (AI) applications and other processes associated with a relatively large quantity of access operations. However, in some cases, a memory system may be constrained with relatively limited storage capacity and bandwidth capabilities, which may be inadequate for handling extensive data volumes. In some other examples, a memory system may support relatively higher storage capacity but may be associated with relatively high latency, impeding data processing speeds. In some cases, capacity enhancements by reducing component size or pitch may be limited based on practical and physical limitations of such techniques.

In accordance with one or more techniques described herein, a memory system 100 may support an architecture that includes ambipolar channels (e.g., ambipolar semiconductor channels, pillar channels, between respective nodes 130 and 135, ambipolar channel portions 131) of a semiconductor material, such as a TMD. In some examples, the use of such semiconductor materials in a channel portion 131 may enable a relatively efficient generation of electrons and holes, which may support faster or lower-power read operations on memory cells 105, faster or lower-power write operations (e.g., faster switching between electron and hole generation, faster charge mobility, faster changes to a stored electric field), or both using respective storage portions 120 of memory cells 105 associated with (e.g., formed along the length of) the ambipolar channel. Such techniques may enable a memory system to support next-generation applications, such as AI applications and other data-intensive processes. For example, by implementing an ambipolar pillar channel, a memory system may support more efficient access operations (e.g., write-in-place algorithms), which may mitigate processing overhead by reducing memory management operations (e.g., garbage collection) and may reduce write amplification effects. Thus, a memory system 100 may be configured to support higher capacity, reduced latency, increased lifespan, reduced power consumption, and other benefits.

**FIG. 2** shows an example of a memory architecture 200 that supports memory architectures with ambipolar semiconductor channels in accordance with examples as disclosed herein. The memory architecture 200 may be an example of a portion of a memory system, such as a memory system 100. Although some elements of a set of elements (e.g., an array of elements) are included in FIG. 2, some elements may be omitted for the sake of visibility and clarity of the depicted elements. Moreover, although some elements included in FIG. 2 are labeled with reference numbers, some other corresponding elements are not labeled, though they would be understood by a person having ordinary skill in the art to be the same as or similar to the labeled elements. Aspects of the memory architecture 200 may be described with reference to an x-direction, a y-direction, and a z-direction of the illustrated coordinate system.

The memory architecture 200 includes a three-dimensional array of memory cells 205, which may be examples of memory cells 105 described with reference to FIG. 1 (e.g., transistors 110, NAND memory cells). In some examples, the memory cells 205 may be connected in a 3D NAND configuration. For example, the memory cells 205 may be included in a block 210, which may be arranged as a 3D array of *m* memory cells along the x-direction, *n* memory cells along the y-direction, and *o* memory cells along the z-direction. Each memory cell 205 may be located (e.g., addressed) in accordance with an index *i* along the x-direction, an index *j* along the y-direction, and an index *k* along the z-direction (e.g., for locating a memory cell 205-a-ijk). A memory system 100 may include any quantity of one or more blocks 210 in accordance with examples as disclosed herein, and different blocks 210 may be adjacent along the x-direction, along the y-direction, or along the z-direction, or any combination thereof.

In the example of memory architecture 200, the block 210 may be divided into a set of pages 215 (e.g., a quantity of *o* pages 215) along the z-direction, including a page 215-a-1 associated with memory cells 205-a-111 through 205-a-mn1. In some examples, each page 215 may be associated with the same word line 265, (e.g., a word line 165 described with reference to FIG. 1), which may be coupled with a control gate 115 of each of the memory cells 205 of the page 215. For example, page 215-a-1 may be associated with a word line 265-a-1, and other pages 215-a-i may be associated with a different respective word line 265-a-i (not shown). In some examples, a word line 265 in accordance with the memory architecture 200 may be implemented as planar conductor (e.g., in an xy-plane) that is coupled with each of the memory cells 205 of the page 215.

In the example of memory architecture 200, the block 210 also may be divided into a set of strings 220 (e.g., a quantity of (*m* x *n*) strings 220) in an xy-plane, including a string 220-a-mn associated with memory cells 205-a-mn1 through 205-a-mno. In some examples, each string 220 may include a set of memory cells 205 connected in series (e.g., along the z-direction, in which a drain of one memory cell 205 in the string 220 may be coupled with a source of another memory cell 205 in the string 220). In some examples, memory cells 205 of a string 220 may be implemented along a common channel, such as a pillar channel (e.g., a columnar channel, a pillar of doped semiconductor) along the z-direction. Each memory cell 205 in a string 220 may be associated with a different word line 265, such that a quantity of word lines 265 in the memory architecture 200 may be equal to the quantity of memory cells 205 in a string 220. Accordingly, a string 220 may include memory cells 205 from multiple pages 215, and a page 215 may include memory cells 205 from multiple strings 220.

In some examples, memory cells 205 may be programmed (e.g., set to a logic 0 value) and read from in accordance with a granularity, such as at the granularity of a page 215 or portion thereof, but may not be erasable (e.g., reset to a logic 1 value) in accordance with the granularity, such as the granularity of a page 215 or portion thereof. For example, NAND memory may instead be erasable in accordance with a different (e.g., higher) level of granularity, such as at the level of granularity the block 210. In some cases, a memory cell 205 may be erased before it may be re-programmed. Different memory devices may have different read, write, or erase characteristics.

In some examples, each string 220 of a block 210 may be coupled with a respective transistor 230 (e.g., a string select transistor, a drain select transistor) at one end of the string 220 (e.g., along the z-direction) and a respective transistor 240 (e.g., a source select transistor, a ground select transistor) at the other end of the string 220. In some examples, a drain of each transistor 230 may be coupled with a bit line 250 of a set of bit lines 250 associated with the block 210, where the bit lines 250 may be examples of bit lines 155 described with reference to FIG. 1. A gate of each transistor 230 may be coupled with a select line 235 (e.g., a string select line, a drain select line). Thus, a transistor 230 may be used to couple a string 220 with a bit line 250 based on applying a voltage to the select line 235, and thus to the gate of the transistor 230. Although illustrated as separate lines along the x-direction, in some examples, select lines 235 may be common to all the transistors 230 associated with the block 210 (e.g., a commonly biased string select node). For example, like the word lines 265 of the block 210, select lines 235 associated with the block 210 may, in some examples, be implemented as a planar conductor (e.g., in an xy-plane) that is coupled with each of the transistors 230 associated with the block 210.

In some examples, a source of each transistor 240 associated with the block 210 may be coupled with a source line 260 of a set of source lines 260 associated with the block 210. In some examples, the set of source lines 260 may be associated with a common source node (e.g., a ground node) corresponding to the block 210. A gate of each transistor 240 may be coupled with a select line 245 (e.g., a source select line, a ground select line). Thus, a transistor 240 may be used to couple a string 220 with a source line 260 based on applying a voltage to the select line 245, and thus to the gate of the transistor 240. Although illustrated as separate lines along the x-direction, in some examples, select lines 245 also may be common to all the transistors 240 associated with the block 210 (e.g., a commonly biased ground select node). For example, like the word lines 265 of the block 210, select lines 245 associated with the block 210 may, in some examples, be implemented as a planar conductor (e.g., in an xy-plane) that is coupled with each of the transistors 240 associated with the block 210.

To operate the memory architecture 200 (e.g., to perform a program operation, a read operation, or an erase operation on one or more memory cells 205 of the block 210), various voltages may be applied to one or more select lines 235 (e.g., to the gate of the transistors 230), to one or more bit lines 250 (e.g., to the drain of one or more transistors 230), to one or more word lines 265, to one or more select lines 245 (e.g., to the gate of the transistors 240), to one or more source lines 260 (e.g., to the source of the transistors 240), or to a bulk for the memory cells 205 (not shown) of the block 210. In some cases, each memory cell 205 of a block 210 may have a common bulk, the voltage of which may be controlled independently of bulks for other blocks 210.

In some cases, as part of a read operation for a memory cell 205, a positive voltage may be applied to the corresponding bit line 250 while the corresponding source line 260 may be grounded or otherwise biased at a voltage lower than the voltage applied to the bit line 250. In some examples, voltages may be concurrently applied to the select line 235 and the select line 245 that are above the threshold voltages of the transistor 230 and the transistor 240, respectively, for the memory cell 205, thereby activating the transistor 230 and transistor 240 such that a channel associated with the string 220 that includes the memory cell 205 (e.g., a pillar channel) may be electrically connected with (e.g., electrically connected between) the corresponding bit line 250 and source line 260. A channel may be an electrical path through the memory cells 205 in the string 220 (e.g., through the sources and drains of the transistors in the memory cells 205 of the string 220) that may conduct current under some operating conditions.

In some examples, multiple word lines 265 (e.g., in some cases all word lines 265) of the block 210-except a word line 265 associated with a page 215 of the memory cell 205 to be read-may concurrently be set to a voltage (e.g., VREAD) that is higher than the threshold voltage (VT) of the memory cells 205. VREAD may cause all memory cells 205 in the unselected pages 215 be activated so that each unselected memory cell 205 in the string 220 may maintain high conductivity within the channel. In some examples, the word line 265 associated with the memory cell 205 to be read may be set to a voltage, VTarget. Where the memory cells 205 are operated as SLC memory cells, VTarget may be a voltage that is between (i) VT of a memory cell 205 in an erased state (e.g., cell state 195-a) and (ii) VT of a memory cell 205 in a programmed state (e.g., cell state 195-b).

When the memory cell 205 to be read exhibits an erased VT (e.g., VTarget > VT of the memory cell 205, associated with cell state 195-a), the memory cell 205 may turn "ON" in response to the application of VTarget to the word line 265 of the selected page 215, which may allow a current to flow in the channel of the string 220, and thus from the bit line 250 to the source line 260. When the memory cell 205 to be read exhibits a programmed VT (e.g., VTarget < VT of the selected memory cell, associated with cell state 195-b), the memory cell 205 may remain "OFF" despite the application of VTarget to the word line 265 of the selected page 215, and thus may prevent a current from flowing in the channel of the string 220, and thus from the bit line 250 to the source line 260.

A signal on the bit line 250 for the memory cell 205 (e.g., an amount of current below or above a threshold) may be sensed (e.g., by a sense component 170 as described with reference to FIG. 1), and may indicate whether the memory cell 205 became conductive or remained non-conductive in response to the application of VTarget to the word line 265 of the selected page 215. The sensed signal thus may be indicative of whether the memory cell 205 was in an erased state (e.g., storing a logic 1) or a programmed state (e.g., storing a logic 0). Though aspects of the example read operation above have been explained in the context of an SLC memory cell 205 for clarity, such techniques may be extended or altered and applied in the context of a multiple-level memory cell 205 (e.g., through the use of multiple values of VTarget corresponding to the different amounts of charge that may be stored in one multiple-level memory cell 205).

In some cases, as part of a program operation for a memory cell 205, an electric field may be stored in a portion of the memory cell 205 (e.g., one or more storage portions 120) such that current flow through the memory cell 205, and thus the corresponding string 220, may be inhibited when the memory cell 205 is later read. For example, charge (e.g., electrons) may be injected into a charge-trapping storage portion 120-a, or a polarization may written to a ferroelectric storage portion 120-b, or both, in accordance with a cell state 195-b. In some cases, respective voltages may be applied to the word line 265 of the page 215 and the bulk of the memory cell 205 (e.g., across a storage portion 120) to be programmed such that a control gate 115 of the memory cell 205 is at a relatively higher voltage (e.g., a positive voltage may be applied to the word line 265). Concurrently, voltages may be applied to the select line 235, the select line 245, or both that are above the threshold voltages of the transistor 230 and the transistor 240, respectively, thereby activating the transistor 230 and/or the transistor 240, and the bit line 250 for the memory cell 205 to be programmed may be set to a relatively high voltage. In some examples, this may cause an electric field such that electrons are pulled into a storage portion 120 of the memory cell 205 (e.g., through dielectric material 125), and thereby injected into the storage portion 120 through a process which may, in some cases, be referred to as tunnel injection), or that alters a polarization of a storage portion 120, or both.

In some cases, a single program operation may program some or all memory cells 205 in a page 215, as the memory cells 205 of the page 215 may all share a common word line 265 and a common bulk. For a memory cell 205 of the page 215 for which it is not desired to write a logic 0 (e.g., not desired to program the memory cell 205), the corresponding bit line 250 may be set to a relatively low voltage (e.g., ground), which may inhibit writing an electric field to a storage portion 120. Though aspects of the example program operation above have been explained in the context of an SLC memory cell 205 for clarity, such techniques may be extended and applied to the context of a multiple-level memory cell 205 (e.g., through the use of multiple programming voltages applied to the word line 265, or multiple passes or pulses of a programming voltage applied to the word line 265, corresponding to the different amounts of electric field that may be stored in one multiple-level memory cell 205).

In some cases, as part of an erase operation for a memory cell 205, an electric field may be stored in a portion of the memory cell 205 (e.g., one or more storage portions 120) such that current flow through the memory cell 205, and thus the corresponding string 220, may be uninhibited (e.g., allowed, at least to a greater extent) when the memory cell 205 is later read. For example, charge (e.g., electrons) may be removed from a charge-trapping storage portion 120-a, or a polarization may written to a ferroelectric storage portion 120-b, or both, in accordance with a cell state 195-b. In some cases, respective voltages may be applied to the word line 265 of the page 215 and the bulk of the memory cell 205 to be erased such that a control gate 115 of the memory cell 205 is at a relatively lower voltage (e.g., a negative voltage may be applied to the word line 265), which may cause an electric field that pulls electrons out of a storage portion 120 and into the bulk of the memory cell 205, or that alters a polarization of a storage portion 120, or both.

In accordance with one or more techniques described herein, a memory architecture 200 may include ambipolar channels (e.g., ambipolar semiconductor channels, pillar channels, along a string 220) of a semiconductor material, such as a TMD. In some examples, the use of such semiconductor materials may enable a relatively efficient generation of electrons and holes, which may support faster or lower-power read operations, or faster or lower-power write operations (e.g., faster switching between electron and hole generation, faster charge mobility, faster changes to a stored electric field), or both using respective portions of one or more storage materials of memory cells 205 associated with (e.g., formed along the length of) the ambipolar channel. For example, such storage materials may store an electric field corresponding to a logic state, and such storage materials may include a charge-trapping material operable to store an electric field by moving charge (e.g., electrons) into or out of the charge-trapping material, or a polarization material (e.g., a ferroelectric material, a dipole material) operable to store an electric field by storing a polarization (e.g., a dipole polarization, a dipole orientation, an electric field polarization, an electric field orientation) by applying a coercive electric field across the polarization material, or a combination thereof. In some examples, storage material(s) may include a ferroelectric layer (e.g., in contact with the semiconductor material), which may complement the ambipolar capability of the semiconductor material (e.g., a faster switching between electron and hole generation, supporting positive and negative electric field orientations) in the context of memory operations.

The described techniques may enable a memory architecture 200 to support next-generation applications, such as AI applications and other data-intensive processes. For example, by implementing an ambipolar pillar channel (e.g., along strings 220), a memory system may support more efficient access operations (e.g., write-in-place algorithms), which may mitigate processing overhead by reducing memory management operations (e.g., garbage collection) and may reduce write amplification effects. For example, compared to other techniques for erasing memory cells 205 (e.g., by biasing a bulk of memory cells 205 of a block 210, by erasing a block 210 concurrently), memory cells 205 that implement an ambipolar channel architecture may additionally, or alternatively, be erased or written in place (e.g., individually, with a different logic state) by changing (e.g., reversing, reducing) a charge or polarization of a corresponding storage portion 120 with a different write bias applied across the storage portion 120 (e.g., applied between a corresponding word line 265 and a corresponding bit line 250). Thus, memory systems may be configured to support higher capacity, reduced latency, increased lifespan, reduced power consumption, and other benefits.

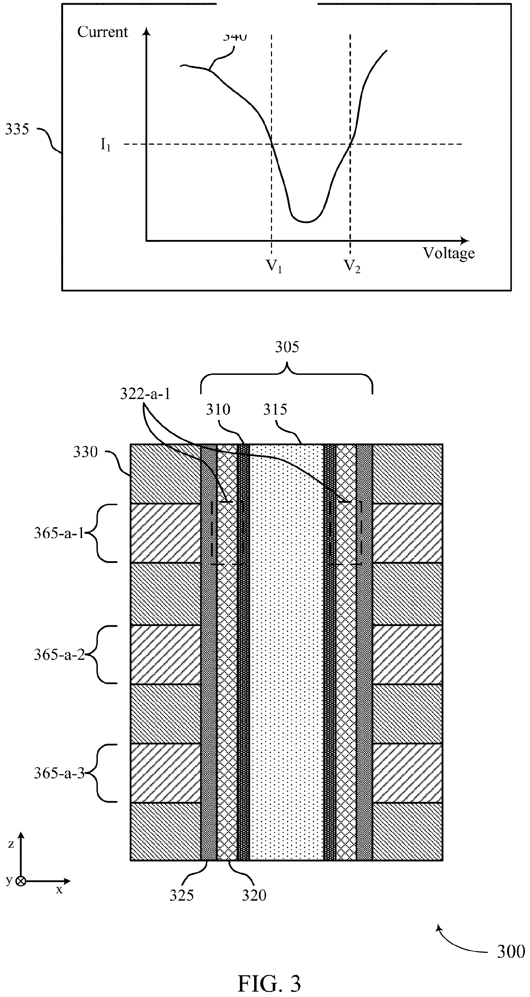

**FIG. 3** shows an example of an architecture 300 that supports memory architectures with ambipolar semiconductor channels in accordance with examples as disclosed herein. The architecture 300 may be an example of or include aspects of the memory system 100 and the memory architecture 200. For example, the architecture 300 may include one or more pillars 305 (e.g., a pillar channel, corresponding to a string 220 implemented along a common channel, a columnar channel, which may be implemented as an array of pillars 305 arranged along the x-direction, along the y-direction, or both) extending along the z-direction, which each may have a cross-sectional shape (e.g., round, circular, elliptical, prismatic) in an xy-plane. The architecture 300 also may include one or more conductors 365 (e.g., word lines 265, word lines 165) distributed along the z-direction (e.g., above a substrate) and each extending along the x-direction, the y-direction, or both (e.g., to support planar word lines 265). Along the pillars 305 (e.g., as part of the pillar(s) 305, arranged along the pillar(s) 305), the architecture 300 may include a storage material(s) 320 including various portions 322 (e.g., corresponding to storage portions 120, which may include charge-trapping storage portions 120-a, ferroelectric storage portions 120-b, or both), and may include a material 330 (e.g., a dielectric material) between conductors 365, and other components corresponding to aspects as described with reference to FIGs. 1 and 2. Aspects of the architecture 300 may be described with reference to an x-direction, a y-direction, and a z-direction of the illustrated coordinate system.

In some examples, a pillar 305 may refer to a structure within a memory device, which may serve a channel for electrical conduction, connecting various layers or components, such as semiconductor materials, charge-trapping materials, dielectric materials, and other materials to facilitate data storage and retrieval operations. For example, a pillar 305 may include a dielectric material 315 (e.g., a core dielectric), a channel 310 (e.g., an ambipolar channel, around the dielectric material 315) formed of a semiconductor material (e.g., a molybdenum disulfide (MoS2) material, or other semiconductor material that exhibits an ambipolar characteristic), storage material(s) 320 (e.g., a ferroelectric material, which may be hafnia based, or include a hafnium oxide material, around the channel 310, or a charge-trapping material, or both), a dielectric material 325 (e.g., a gate interlayer, a gate dielectric, a dielectric material 125, around the storage material(s) 320, which may, in some examples, act as a charge-trapping material), or any combination thereof.

In some examples, the architecture 300 may implement (e.g., utilize, leverage) a channel 310 that is associated with (e.g., exhibits) an ambipolar characteristic, and may be referred to as an ambipolar channel 310. For example, the semiconductor material of a channel 310 may become conductive based on two or more different ranges of activation voltages (e.g., a negative range of voltages and a positive range of voltages). For example, the channel 310 may be activated based on voltages (e.g., one or more gate voltages, one or more activation voltages, voltages of one or more conductors 365) that are either below a first threshold voltage (e.g., V₁) or above a second threshold voltage (e.g., V₂). In some examples, one or more TMD materials may be used for the channel 310 (e.g., NAND memory channels, offering advantages in pitch scaling and performance enhancement in memory systems) based on an ambipolar conduction capability. Among such materials, MoS2 may be a nonlimiting example of a material that exhibits a set of characteristics suitable for an ambipolar channel 310. In some examples, a deposition of MoS2 may be based on one or more techniques such as atomic layer deposition (ALD) or plasma-enhanced chemical vapor deposition (PVCVD) for integration into memory architectures (e.g., such as the architecture 300).

In some examples, TMD materials (e.g., including MoS2) may, based on their ambipolar conduction capability, support dual polarity high-speed operations. For example, using a TMD material as a semiconductor may enable rapid generation of both electrons and holes along channels 310. In contrast, other architectures (e.g., other 3D NAND architectures) may use a polysilicon material along a channel, which may be associated with relatively slow hole generation (e.g., due to a gate-induced drain leakage (GIDL) process), resulting in relatively slow erase operations (e.g., which contribute to data being erased at a block level of granularity rather than a page level or cell level). However, channels 310 (e.g., a hollow channel, a hollow ambipolar MoS2 channel) may overcome or alleviate such limitations by facilitating relatively faster programming operations and erase operations on the memory cells (e.g., thus enhancing FeNAND devices). Moreover, TMD materials (e.g., MoS2) may provide a higher string current as compared to other materials (e.g., polysilicon), which may enable relatively faster read operations. In some examples, using the TMD materials as part of the architecture 300 (e.g., when a memory array is organized in a tile-like configuration) may mitigate resistive-capacitive characteristics of word lines 265 (e.g., of conductors 365).

For example, the plot 335 may illustrate an example of a curve 340 that exhibits an ambipolar conduction of a TMD material (e.g., MoS2). The horizontal axis of the plot 335 may represent voltage values (e.g., in units of volts (V)), and the vertical axis of the plot 335 may represent conduction values or current values (e.g., in units of Amperes (A), in a logarithmic scale). In some examples, a TMD material may be activated when a conductivity (e.g., I) is above a threshold conductivity, I₁, in response to an applied activation voltage. For example, the TMD material may be activated (e.g., have a conductivity or current above I₁) in response to activation voltages that are below or equal to a first threshold voltage, V₁. The TMD material may also be activated (e.g., have a conductivity or current above I₁) in response to activation voltages that are above or equal to a second threshold voltage, V₂. The TMD material may be deactivated (e.g., have a conductivity or current below I₁) in response to activation voltages that are between the first threshold voltage, V₁, and the second threshold voltage, V₂. In some examples, V₁ may be a negative voltage (e.g., less than a ground voltage, a negative threshold voltage) and V₂ may be a positive voltage (e.g., greater than a ground voltage, a positive threshold voltage).

In some examples, the storage material(s) 320 may include various portions 322, which each may be associated with a respective conductor 365 (e.g., associated with a word line 265, associated with a memory cell 205) and may be the location where one or more logic states (e.g., data bits) are stored. For example, the portion 322-a-1 of the storage material(s) 320 (e.g., wrapping around the pillar 305, outside the channel 310) may be associated with the conductor 365-a-1 and may store a logic state (e.g., an electric field) based on operation of the conductor 365-a-1 and the channel 310.

In some examples, the storage material(s) 320 may include a ferroelectric material (e.g., a ferroelectric storage portion 120-b). In such examples, a polarization (e.g., a dipole polarization, a dipole orientation, a charge distribution) may be induced by an electric field into the ferroelectric material of the storage material(s) 320 (e.g., of a respective portion 322). Additionally, or alternatively, the storage material(s) 320 may include a charge-trapping material (e.g., a charge-trapping storage portion 120-a). In such examples, a charge (e.g., a positive charge or negative charge) may be injected by the electric field into a channel interlayer portion due to the electric field (e.g., by way of electron injection or removal). Thus, a memory cell associated with the storage material(s) 320 may be operable to store a respective logic state based on a charge stored in a respective portion of the charge-trapping material of the storage material(s) 320, on a dipole orientation stored in a respective portion of the ferroelectric material of the storage material(s) 320, or both (e.g., as a stored electric field between a conductor 365 and the channel 310.

In some examples, a polarization voltage (e.g., a saturation voltage, associated with polarizing at least one of the storage material(s) 320) can be applied to the storage material(s) 320 with a magnitude that is greater than a gate activation voltage applied to conductors 365 (e.g., a voltage less than V₁ for a first charge state, a voltage greater than V₂ for a second charge state). In some examples, an activation voltage of the channel 310 (e.g., V₁, V₂) may have a magnitude that is less than a voltage that disturbs a cell state 195 (e.g., a stored electric field) of the storage material(s) 320, such that portions of the channel 310 can be activated without disturbing logic states stored in the storage material(s) 320 along the pillar 305. In some examples, the channel 310 may be in direct contact with the storage material(s) 320 (e.g., no material may be present between the ferroelectric material and TMD channel). The storage material(s) 320 may also be in contact with one or more dielectric materials 325 (e.g., a gate interlayer). The dielectric material 325 may include a combination of multiple dielectric layers or may include a single dielectric material.

In some examples, the architecture 300 may further include one or more select lines (e.g., select lines 245), source lines (e.g., source lines 260), and other components that facilitate the operation of the architecture 300. Such features may support the architecture 300 being implemented in a tile-like array architecture that integrates multiple pillars 305 (e.g., each including multiple memory cells) to increase access speed performance and reduce power consumption. In some examples, the architecture 300 may support more efficient memory access operations, such as a write-in-place array operation. Such operations may reduce (e.g., eliminate) relatively slower operations (e.g., operations for hole generation) associated with GIDL at a block of memory cells.

As an illustrative example, a memory device may include a set of multiple of conductors 365, which may be distributed along a direction (e.g., a z-direction) from a substrate (not shown) of the memory device. In some examples, each of the conductors 365 may be associated with a respective one of a set of multiple activation lines (e.g., word lines 265) of a memory array. In some examples, the memory device may include a pillar 305, which may extend along the direction from the substrate and through the set of conductors 365. The pillar 305 may include a semiconductor material extending along a length of the pillar 305 and associated with an ambipolar channel 310 along the length of the pillar 305.

In some examples, a conductivity of the ambipolar channel 310 may be above a threshold conductivity (e.g., above I₁, may be activated, may facilitate a transfer of holes) in response to activation voltages below a first threshold voltage (e.g., below V₁). In some examples, the conductivity of the ambipolar channel 310 may be above the threshold conductivity (e.g., above I₁, may be activated, may facilitate a transfer of electrons) in response to activation voltages above a second threshold voltage (e.g., above V₂). In some examples, the conductivity of the ambipolar channel 310 may be below the threshold conductivity (e.g., below I₁, may be deactivated) in response to activation voltages between the first threshold voltage and the second threshold voltage. In some examples, the semiconductor material of the channel 310 may include a TMD material (e.g., MoS2). Additionally, or alternatively, the semiconductor material may be a layer of semiconductor material around a dielectric core (e.g., the dielectric material 315) of the pillar 305.

In some examples, the architecture 300 may include a set of multiple portions 322 of a storage material(s) 320. Each portion 322 of the storage material(s) 320 may be associated with a respective memory cell of the memory array and may be positioned between a respective conductor 365 and a respective portion of the semiconductor material (e.g., of the channel 310) along the length of the pillar 305 (e.g., in the z-direction). In some examples, the storage material(s) 320 may include a ferroelectric material. In some examples, the portions 322 of the storage material(s) 320 may be included in a continuous formation of the storage material(s) 320 around the semiconductor material. Additionally, or alternatively, the portions 322 of the storage material(s) 320 may be discontinuous formation of the storage material(s) 320 around the semiconductor material (e.g., formed between layers of material 330, with corresponding discontinuous portions of dielectric material 325).

In some examples, each portion 322 of the storage material(s) 320 may be in contact with a respective portion of the semiconductor material (e.g., of the channel 310). In some examples, each of the memory cells (e.g., associated with the portions 322, SLCs, MLCs, TLCs, QLCs, or a combination thereof) may be operable to store a respective logic state based on an electric field (e.g., polarization, charge, or combination thereof) stored in the respective portion 322 of the storage material(s) 320. In some examples, the architecture 300 may include one or more dielectric materials 325 positioned between the conductors 365 and the portions 322 of the storage material(s) 320. In some examples, the architecture 300 may include a first select line (e.g., a select line 245) operable to couple a first end of the pillar 305 with a first access line (e.g., a source line 260) of the memory array and may include a second select line (e.g., a select line 235) operable to couple a second end of the pillar 305 with a second access line (e.g., a bit line 250) of the memory array.

Accordingly, by utilizing the architecture 300, a memory system may support implement of relatively advanced and data-intensive applications. For example, by including an ambipolar channel 310, the memory system may support relatively faster access operations enabling more-efficient data processing, reducing latency and reduced power consumption. Moreover, the ambipolar characteristics of the channel 310 and the storage material(s) 320 (e.g., ferroelectric material, charge-trapping material, or combination thereof) may result in reduced processing overhead based on an ability to support more efficient memory access algorithms, such as write-in-place algorithms. Thus, memory systems may be configured to operate with higher capacity, reduced latency, increased lifespan, and reduced power consumption, among other benefits.

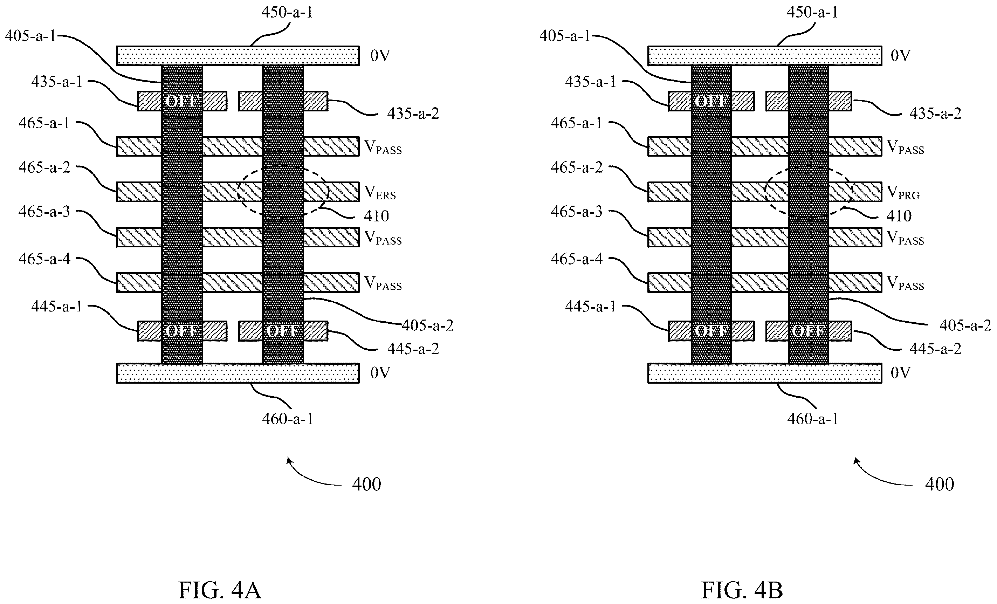

**FIGs. 4A and 4B** show examples of operations on an architecture 400 that supports memory architectures with ambipolar semiconductor channels in accordance with examples as disclosed herein. For example, FIG. 4A may show a first set of operations performed on the architecture 400, and FIG. 4B may show a second set of operations performed on the architecture 400. In some examples, the one or more operations performed on the architecture 400 may be referred to as a write-in-place procedure, a write-in-place algorithm, or a write-in-place operation.

The architecture 400 (e.g., a memory device) may implement or be implemented by aspects of the memory system 100, the memory architecture 200, and the architecture 300 as described with reference to FIGs. 1 through 3. For example, the architecture 400 may include one or more pillars 405 (e.g., of a string 220) and one or more activation lines 465 (e.g., word lines 265), which may be examples of a pillar 305 and conductors 365, respectively. The architecture 400 may also include one or more select lines 435 (e.g., select lines 235), one or more access lines 450 (e.g., bit lines 250), one or more select lines 445 (e.g., select lines 245), one or more access lines 460 (e.g., source lines 260), or any combination thereof. For example, the memory device may include select lines 435-a-1 and 435-a-2 operable to couple or isolate respective first ends of one or more pillars 405 with access line 450-a-1 (e.g., via respective transistors 230), and may include select lines 445-a-1 and 445-a-2 operable to couple or isolate respective second ends of the one or more pillars 405 with access line 460-a-1 (e.g., via respective transistors 240).

In some examples, one or more operations (e.g., memory access operations, program operations, erase operations) may be performed on the architecture 400. The one or more operations may be performed by a memory controller 180 or some other circuitry of the memory system. For example, an access operation may include biasing one or more activation lines 465 (e.g., word lines) with one or more voltages (e.g., V_{PASS}, V_{ERS}, V_{PRG}). As described herein, "biasing" may refer to a process of applying a voltage to a device or component, such as an activation line 465, to establish a reference level for its operation.

A first set of operations may be performed, as shown in the example of FIG. 4A. The first set of operations may be associated with erasing a logic state (e.g., clearing, resetting, writing a cell state 195-a, writing an "ERASE" state) from a memory cell 410 (e.g., a memory cell 205) along the pillar 405-a-2. The pillar 405-a-2 may be associated with an ambipolar semiconductor channel (e.g., a channel 310) extending along a length of the pillar 405-a-2 and through the activation lines 465 (e.g., and select lines 435-a-2 and 445-a-2). In some examples, the first operations (e.g., erase operations) may be performed in response to (e.g., based on) a write command (e.g., received from a host system or another device), and may, in some examples, be before performing one or more other writing operations (e.g., the erase operation may be a first step of a cell programming procedure).

In some examples, erasing the logic state may include biasing the pillar 405-a-2 with a first voltage (e.g., 0V). In some examples, biasing the pillar 405-a-2 with the first voltage may be based on (e.g., in response to) coupling the pillar 405-a-2 with the access line 450-a-1 (e.g., based on applying an activation voltage to select line 435-a-2). In some examples, the access line 450-a-1 may be coupled with a first end of the pillar 405-a-2, and the first operations may include isolating a second end of the pillar 405-a-2 (e.g., opposite the first end) from the access line 460-a-1 (e.g., based on applying a deactivation voltage to the select line 445-a-2) while the pillar is coupled with access line 450-a-1. In some examples, the first operations may further include (e.g., during the erase operation) isolating a first end of a pillar 405-a-1 from the access line 450-a-1 (e.g., based on applying a deactivation voltage to the select line 435-a-1) and isolating a second end of the pillar 405-a-1 from the access line 460-a-1 (e.g., based on applying a deactivation voltage to the select line 445-a-1).

In some examples, the first operations may include biasing the activation line 465-a-2 with a second voltage (e.g., V_{ERS}, a positive gate voltage, +Vg, where +Vg may be equal to +3V) that is greater than the first voltage. The second voltage may be based on a thickness of storage material(s) 320 (e.g., of a ferroelectric layer, of a charge-trapping layer) of a pillar 405, or based on an electric field generation (e.g., for a removal of electrons, for a change of polarization) of the memory cell 410, or both. In some examples, biasing the activation line 465-a-2 with the second voltage (e.g., with a difference between the second voltage and the first voltage being greater than threshold voltage V₂) may be configured to activate a first portion (e.g., a portion 322, associated with the memory cell 410) of the ambipolar semiconductor channel (e.g., of the pillar 405-a-2).

In some examples, the first operations may include biasing one or more activation lines 465 other than the activation line 465-a-2 (e.g., activation lines 465-a-1, 465-a-3, and 465-a-4) with a third voltage (e.g., V_{PASS}, +V_{PASS}), which may be different than the first voltage and the second voltage. In some examples, the third voltage may also be greater than the first voltage (e.g., may be a positive voltage), but may have a lower magnitude than the second voltage (e.g., 2V, may be between the first and second voltages). In some other examples, the third voltage may be less than the first voltage (e.g., may be a negative voltage). In some examples, biasing the one or more activation lines 465 other than the activation line 465-a-2 with the third voltage (e.g., with a difference between the third voltage and the first voltage also being greater than threshold voltage V₂, with a difference between the third voltage and the first voltage being less than threshold voltage V₁) may be configured to activate one or more second portions of the ambipolar semiconductor channel. In some examples, an absolute difference between the second voltage (e.g., V_{ERS}) and the first voltage (e.g., 0V) may be greater than an absolute difference between the third voltage (e.g., V_{PASS}) and the first voltage (e.g., to support changing a stored electric field at the memory cell 410 while also activating other portions of the channel along pillar 405-a-2, such as with a lower voltage magnitude).

In some examples, the first operations may include storing a charge (e.g., a positive charge, representative of a logic state, representative of an erased state, representative of an initialized state) in one or more storage materials 320 between the activation line 465-a-2 and the ambipolar semiconductor channel of the pillar 405-a-2. In some examples, the storing may be based on biasing the pillar 405-a-2 with the first voltage, biasing the activation line 465-a-2 with the second voltage, and biasing the other activation lines 465 with the third voltage. In some examples, erasing the logic state from the memory cell 410 may be based on a transfer of electrons from a charge-trapping storage portion 120-a. That is, the first operations may facilitate a transfer of electrons (e.g., a removal of electrons) from a charge-trapping material of the memory cell 410 (e.g., within a threshold duration).

Additionally, or alternatively, the first operations may include storing a first polarization (e.g., a dipole polarization) in one or more storage materials 320 between the activation line 465-a-2 and the ambipolar semiconductor channel of the pillar 405-a-2 (e.g., orienting dipoles 121 of a ferroelectric storage portion 120-b, to support an electric field orientation that is positive from the activation line 465-a-2 to the pillar 405-a-2). In such examples, the first polarization may create a first dipole, where a concentration of negative charges may be stored at a first side of the ferroelectric material and a concentration of positive charges may be stored at a second side of the ferroelectric material opposite the first side. In such examples, the first side of the ferroelectric material may be oriented toward the activation line 465-a-2 (e.g., in contact with or toward a dielectric material 325), and the second side of the ferroelectric material may be oriented toward the pillar 405-a-2 (e.g., in contact with or toward a channel 310, a portion of the ambipolar channel).

A second set of operations may be performed, as shown in the example of FIG. 4B. The second set of operations may be associated with writing a logic state (e.g., programming, writing a cell state 195-b, writing a "PROGRAM" state) to the memory cell 410. In some examples, the second operations may be performed in response to a write command (e.g., received from a host system or another device). The second set of operations may be performed in response to (e.g., after, based on, in conjunction with) the first set operations (e.g., of FIG. 4A), or may be performed independent of other operations.

In some examples, writing the logic state may include biasing the pillar 405-a-2 with the first voltage (e.g., 0V). In some examples, biasing the pillar 405-a-2 with the first voltage may be based on (e.g., in response to) coupling the pillar 405-a-2 with the access line 450-a-1 (e.g., based on applying an activation voltage to select line 435-a-2). In some examples, the access line 450-a-1 may be coupled with a first end of the pillar 405-a-2, and the second operations may include isolating a second end of the pillar 405-a-2 (e.g., opposite the first end) from the access line 460-a-1 (e.g., based on applying a deactivation voltage to the select line 445-a-2) while the pillar is coupled with access line 450-a-1. In some examples, the second operations may further include (e.g., during the writing operation) isolating a first end of a pillar 405-a-1 from the access line 450-a-1 (e.g., based on applying a deactivation voltage to the select line 435-a-1) and isolating a second end of the pillar 405-a-1 from the access line 460-a-1 (e.g., based on applying a deactivation voltage to the select line 445-a-1).

In some examples, the second operations may include biasing the activation line 465-a-2 with a fourth voltage (e.g., V_{PGR}, a negative gate voltage, -Vg, which may be equal to -3V) that is less than the first voltage. The fourth voltage may be based on a thickness of storage material(s) 320 of a pillar 405, or based on an electric field generation of the memory cell 410, or both. In some examples, the activation line 465-a-2 may be coupled with the memory cell 410. In some examples, biasing the activation line 465-a-2 with the fourth voltage (e.g., with a difference between the fourth voltage and the first voltage being less than threshold voltage V₁) may be configured to activate a first portion (e.g., a portion 322, associated with the memory cell 410) of the ambipolar semiconductor channel (e.g., of the pillar 405-a-2).

In some examples, the second operations may include biasing one or more activation lines 465 other than the activation line 465-a-2 (e.g., activation lines 465-a-1, 465-a-3, and 465-a-4) with a fifth voltage (e.g., V_{PASS}, -V_{PASS}), which may be different than the first voltage and the fourth voltage. In some examples, the fifth voltage may also be less than the first voltage (e.g., may be a negative voltage), but may have a lower magnitude than the second voltage (e.g., -2V, may be between the first and fourth voltages). In some other examples, the fifth voltage may be greater than the first voltage (e.g., may be a positive voltage). In some examples, biasing the one or more activation lines 465 other than the activation line 465-a-2 with the fifth voltage (e.g., with a difference between the fifth voltage and the first voltage also being less than threshold voltage V₁, with a difference between the fifth voltage and the first voltage being greater than threshold voltage V₂) may be configured to activate one or more second portions of the ambipolar semiconductor channel. In some examples, an absolute difference between the fourth voltage (e.g., V_{PRG}) and the first voltage (e.g., 0V) may be greater than an absolute difference between the third voltage (e.g., -V_{PASS}) and the first voltage (e.g., to support changing a stored electric field at the memory cell 410 while also activating other portions of the channel along pillar 405-a-2, such as with a lower voltage magnitude).

In some examples, the second operations may include storing a charge (e.g., a negative charge, representative of a logic state, representative of a programmed state) in one or more storage materials 320 between the activation line 465-a-2 and the ambipolar semiconductor channel of the pillar 405-a-2. In some examples, the storing may be based on biasing the pillar 405-a-2 with the first voltage, biasing the activation line 465-a-2 with the fourth voltage, and biasing the other activation lines 465 with the fifth voltage. In some examples, writing the logic state from the memory cell 410 may be based on a transfer of electrons to a charge-trapping storage portion 120-a. That is, the second operations may facilitate a transfer of electrons (e.g., an injection of electrons) into a charge-trapping material of the memory cell 410 (e.g., within a threshold duration).

Additionally, or alternatively, the second operations may include storing a second polarization (e.g., a dipole polarization) in one or more storage materials 320 between the activation line 465-a-2 and the ambipolar semiconductor channel of the pillar 405-a-2 (e.g., orienting dipoles 121 of a ferroelectric storage portion 120-b, to support an electric field orientation that is negative from the activation line 465-a-2 to the pillar 405-a-2). In such examples, the second polarization may create a second dipole, where a concentration of positive charges may be stored at a first side of the ferroelectric material and a concentration of negative charges may be stored at a second side of the ferroelectric material opposite the first side. In such examples, the first side of the ferroelectric material may be oriented toward the activation line 465-a-2 (e.g., in contact with or toward a dielectric material 325), and the second side of the ferroelectric material may be oriented toward the pillar 405-a-2 (e.g., in contact with or toward a channel 310, a portion of the ambipolar channel).

Accordingly, by applying the one or more operations described herein, a memory device may support erase operations and program operations at a cell level granularity. Such improvements may enable a memory device to implement write-in-place operations in which where data is written on a per cell basis and may reduce other memory management operations (e.g., garbage collection). For example, data may be written directly to its final location, streamlining the write process and minimizing unnecessary data movement. As a result, such techniques may accelerate programming speed and reduce latency, which may support high-performance applications such as AI and real-time data processing. The techniques may also reduce write amplification effects (e.g., by avoiding garbage collection operations), thereby enhancing the overall efficiency and lifespan of the memory system. Additionally, the reduction in write amplification may lead to lower power consumption, making the memory system more energy-efficient.

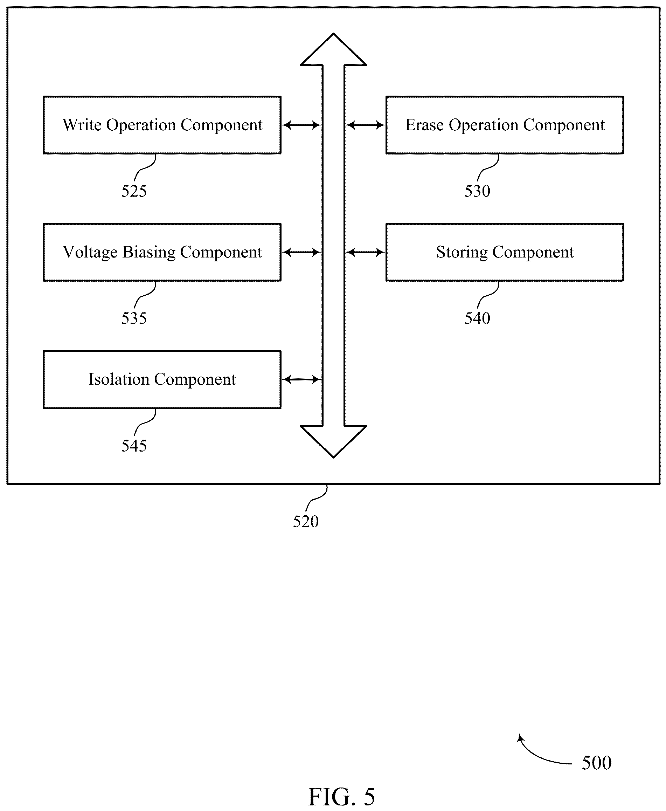

**FIG. 5** shows a block diagram 500 of a memory device 520 that supports memory architectures with ambipolar semiconductor channels in accordance with examples as disclosed herein. The memory device 520 may be an example of aspects of a memory system (e.g., a memory device) as described with reference to FIGs. 1 through 4. The memory device 520, or various components thereof, may be an example of means for performing various aspects of memory architectures with ambipolar semiconductor channels as described herein. For example, the memory device 520 may include a write operation component 525, an erase operation component 530, a voltage biasing component 535, a storing component 540, an isolation component 545, or any combination thereof. Each of these components, or components of subcomponents thereof (e.g., one or more processors, one or more memories), may communicate, directly or indirectly, with one another (e.g., via one or more buses).

The memory device 520 may support operating a memory device in accordance with examples as disclosed herein. The write operation component 525 may be configured as or otherwise support a means for writing a logic state to a memory cell of a memory array. In some examples, to the write, the voltage biasing component 535 may be configured as or otherwise support a means for biasing a pillar with a first voltage, the pillar associated with an ambipolar semiconductor channel extending along a length of the pillar through a plurality of activation lines of the memory array. The voltage biasing component 535 may be configured as or otherwise support a means for biasing a first activation line of the plurality of activation lines with a second voltage that is less than the first voltage, the first activation line coupled with the memory cell. The voltage biasing component 535 also may be configured as or otherwise support a means for biasing one or more second activation lines of the plurality of activation lines, other than the first activation line, with a third voltage that is different than the first voltage and the second voltage. The storing component 540 may be configured as or otherwise support a means for storing an electric field in one or more storage materials based at least in part on biasing the pillar with the first voltage, biasing the first activation line with the second voltage, and biasing the one or more second activation lines with the third voltage, the one or more storage materials being positioned between the first activation line and the ambipolar semiconductor channel.

In some examples, biasing the first activation line with the second voltage that is less than the first voltage is configured to activate a first portion of the ambipolar semiconductor channel. In some examples, biasing the one or more second activation lines with the third voltage that is different than the first voltage and the second voltage is configured to activate one or more second portions of the ambipolar semiconductor channel.

In some examples, an absolute difference between the second voltage and the first voltage is greater than an absolute difference between the third voltage and the first voltage.

In some examples, the third voltage is between the first voltage and the second voltage.

In some examples, biasing the pillar with the first voltage is based at least in part on coupling the pillar with an access line of the memory array that is biased with the first voltage.

In some examples, the access line is coupled with a first end of the pillar, and the isolation component 545 may be configured as or otherwise support a means for isolating a second end of the pillar from a second access line of the memory array while the pillar is coupled with access line.

In some examples, the isolation component 545 may be configured as or otherwise support a means for isolating a first end of a second pillar from the access line during the writing, the second pillar associated with a second ambipolar semiconductor channel extending along a length of the second pillar through the plurality of activation lines. In some examples, the isolation component 545 may be configured as or otherwise support a means for isolating a second end of the second pillar from the second access line during the writing.

In some examples, the erase operation component 530 may be configured as or otherwise support a means for erasing the memory cell. In some examples, the voltage biasing component 535 may be configured as or otherwise support a means for biasing the pillar with the first voltage. In some examples, the voltage biasing component 535 may be configured as or otherwise support a means for biasing the first activation line with a fourth voltage that is greater than the first voltage. In some examples, the voltage biasing component 535 may be configured as or otherwise support a means for biasing the one or more second activation lines with a fifth voltage that is different than the first voltage and the fourth voltage. In some examples, the storing component 540 may be configured as or otherwise support a means for storing a second electric field in the one or more storage materials based at least in part on biasing the pillar with the first voltage, biasing the first activation line with the fourth voltage, and biasing the one or more second activation lines with the fifth voltage.

In some examples, biasing the first activation line with the fourth voltage that is greater than the first voltage is configured to activate a first portion of the ambipolar semiconductor channel. In some examples, biasing the one or more second activation lines with the fifth voltage that is different than the first voltage and the fourth voltage is configured to activate one or more second portions of the ambipolar semiconductor channel.

In some examples, an absolute difference between the fourth voltage and the first voltage is greater than an absolute difference between the fifth voltage and the first voltage.

In some examples, the fifth voltage is between the first voltage and the fourth voltage.

In some examples, the erasing is performed in response to a write command before the writing.

In some examples, the one or more storage materials include a charge-trapping material, a ferroelectric material, or both.

In some examples, storing the electric field includes storing a charge in a charge-trapping material of the one or more storage materials.

In some examples, storing the electric field includes storing a polarization of a ferroelectric material of the one or more storage materials.

In some examples, the described functionality of the memory device 520, or various components thereof, may be supported by or may refer to at least a portion of at least one processor, where such at least one processor may include one or more processing elements (e.g., a controller, a microprocessor, a microcontroller, a digital signal processor, a state machine, discrete gate logic, discrete transistor logic, discrete hardware components, or any combination of one or more of such elements). In some examples, the described functionality of the memory device 520, or various components thereof, may be implemented at least in part by instructions (e.g., stored in memory, non-transitory computer-readable medium) executable by such at least one processor.

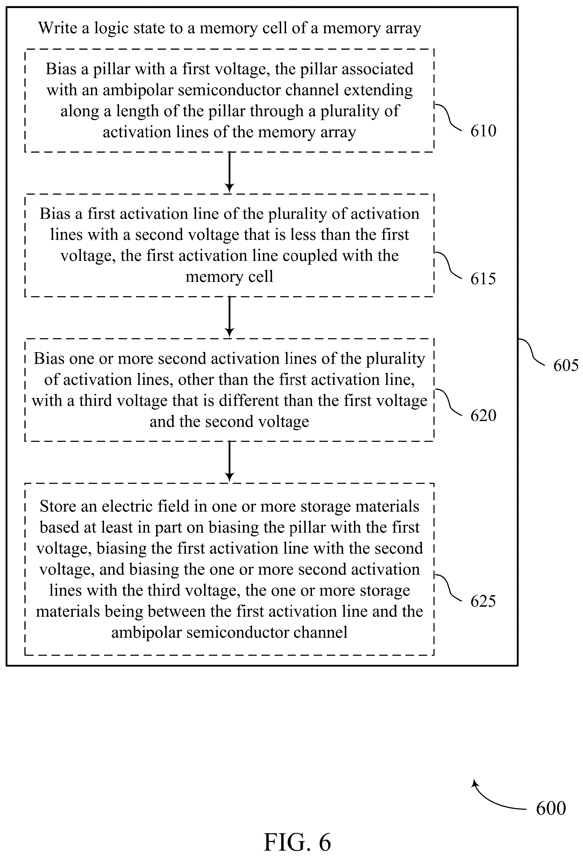

**FIG. 6** shows a flowchart illustrating a method 600 that supports memory architectures with ambipolar semiconductor channels in accordance with examples as disclosed herein. The operations of method 600 may be implemented by a memory system or its components as described herein. For example, the operations of method 600 may be performed by a memory system as described with reference to FIGs. 1 through 5. In some examples, a memory system may execute a set of instructions to control the functional elements of the device to perform the described functions. Additionally, or alternatively, the memory system may perform aspects of the described functions using special-purpose hardware.

At 605, the method may include writing a logic state to a memory cell of a memory array. In some examples, aspects of the operations of 605 may be performed by a write operation component 525 as described with reference to FIG. 5.

At 610, the writing may include biasing a pillar with a first voltage, the pillar associated with an ambipolar semiconductor channel extending along a length of the pillar through a plurality of activation lines of the memory array. In some examples, aspects of the operations of 610 may be performed by a write operation component 525 as described with reference to FIG. 5.

At 615, the writing may include biasing a first activation line of the plurality of activation lines with a second voltage that is less than the first voltage, the first activation line coupled with the memory cell. In some examples, aspects of the operations of 615 may be performed by a write operation component 525 as described with reference to FIG. 5.

At 620, the writing may include biasing one or more second activation lines of the plurality of activation lines, other than the first activation line, with a third voltage that is different than the first voltage and the second voltage. In some examples, aspects of the operations of 620 may be performed by a write operation component 525 as described with reference to FIG. 5.

At 625, the writing may include storing an electric field in one or more storage materials based at least in part on biasing the pillar with the first voltage, biasing the first activation line with the second voltage, and biasing the one or more second activation lines with the third voltage, the one or more storage materials being between the first activation line and the ambipolar semiconductor channel. In some examples, aspects of the operations of 625 may be performed by a write operation component 525 as described with reference to FIG. 5.

In some examples, an apparatus as described herein may perform a method or methods, such as the method 600. The apparatus may include features, circuitry, logic, means, or instructions (e.g., a non-transitory computer-readable medium storing instructions executable by a processor), or any combination thereof for performing the following aspects of the present disclosure:
Aspect 1: A method, apparatus, or non-transitory computer-readable medium including operations, features, circuitry, logic, means, or instructions, or any combination thereof for writing a logic state to a memory cell of a memory array, where the writing includes biasing a pillar with a first voltage, the pillar associated with an ambipolar semiconductor channel extending along a length of the pillar through a plurality of activation lines of the memory array, biasing a first activation line of the plurality of activation lines with a second voltage that is less than the first voltage, the first activation line coupled with the memory cell, biasing one or more second activation lines of the plurality of activation lines, other than the first activation line, with a third voltage that is different than the first voltage and the second voltage, and storing an electric field in one or more storage materials based at least in part on biasing the pillar with the first voltage, biasing the first activation line with the second voltage, and biasing the one or more second activation lines with the third voltage, the one or more storage materials being positioned between the first activation line and the ambipolar semiconductor channel.
Aspect 2: The method, apparatus, or non-transitory computer-readable medium of aspect 1, where biasing the first activation line with the second voltage that is less than the first voltage is configured to activate a first portion of the ambipolar semiconductor channel and biasing the one or more second activation lines with the third voltage that is different than the first voltage and the second voltage is configured to activate one or more second portions of the ambipolar semiconductor channel.
Aspect 3: The method, apparatus, or non-transitory computer-readable medium of any of aspects 1 through 2, where an absolute difference between the second voltage and the first voltage is greater than an absolute difference between the third voltage and the first voltage.
Aspect 4: The method, apparatus, or non-transitory computer-readable medium of any of aspects 1 through 3, where the third voltage is between the first voltage and the second voltage.
Aspect 5: The method, apparatus, or non-transitory computer-readable medium of any of aspects 1 through 4, where biasing the pillar with the first voltage is based at least in part on coupling the pillar with an access line of the memory array that is biased with the first voltage.
Aspect 6: The method, apparatus, or non-transitory computer-readable medium of aspect 5, where the access line is coupled with a first end of the pillar and the method, apparatuses, and non-transitory computer-readable medium further includes operations, features, circuitry, logic, means, or instructions, or any combination thereof for isolating a second end of the pillar from a second access line of the memory array while the pillar is coupled with access line.
Aspect 7: The method, apparatus, or non-transitory computer-readable medium of aspect 6, further including operations, features, circuitry, logic, means, or instructions, or any combination thereof for isolating a first end of a second pillar from the access line during the writing, the second pillar associated with a second ambipolar semiconductor channel extending along a length of the second pillar through the plurality of activation lines and isolating a second end of the second pillar from the second access line during the writing.
Aspect 8: The method, apparatus, or non-transitory computer-readable medium of any of aspects 1 through 7, further including operations, features, circuitry, logic, means, or instructions, or any combination thereof for erasing the memory cell, where the erasing includes; biasing the pillar with the first voltage; biasing the first activation line with a fourth voltage that is greater than the first voltage; biasing the one or more second activation lines with a fifth voltage that is different than the first voltage and the fourth voltage; and storing a second electric field in the one or more storage materials based at least in part on biasing the pillar with the first voltage, biasing the first activation line with the fourth voltage, and biasing the one or more second activation lines with the fifth voltage.
Aspect 9: The method, apparatus, or non-transitory computer-readable medium of aspect 8, where biasing the first activation line with the fourth voltage that is greater than the first voltage is configured to activate a first portion of the ambipolar semiconductor channel and biasing the one or more second activation lines with the fifth voltage that is different than the first voltage and the fourth volage is configured to activate one or more second portions of the ambipolar semiconductor channel.
Aspect 10: The method, apparatus, or non-transitory computer-readable medium of any of aspects 7 through 9, where an absolute difference between the fourth voltage and the first voltage is greater than an absolute difference between the fifth voltage and the first voltage.
Aspect 11: The method, apparatus, or non-transitory computer-readable medium of any of aspects 7 through 10, the fifth voltage is between the first voltage and the fourth voltage.
Aspect 12: The method, apparatus, or non-transitory computer-readable medium of any of aspects 7 through 11, where the erasing is performed in response to a write command before the writing.
Aspect 13: The method, apparatus, or non-transitory computer-readable medium of any of aspects 1 through 12, where the one or more storage materials include a charge-trapping material, a ferroelectric material, or both.
Aspect 14: The method, apparatus, or non-transitory computer-readable medium of any of aspects 1 through 13, where storing the electric field includes storing a charge in a charge-trapping material of the one or more storage materials.
Aspect 15: The method, apparatus, or non-transitory computer-readable medium of any of aspects 1 through 14, where storing the electric field includes storing a polarization of a ferroelectric material of the one or more storage materials.

It should be noted that the described methods include possible implementations, and that the operations and the steps may be rearranged or otherwise modified and that other implementations are possible. Further, portions from two or more of the methods may be combined.

An apparatus is described. The following provides an overview of aspects of the apparatus as described herein:
Aspect 16: A memory device, including: a plurality of conductors distributed along a direction from a substrate of the memory device, each of the plurality of conductors associated with a respective one of a plurality of activation lines of a memory array; a pillar extending along the direction from the substrate and through the plurality of conductors, the pillar including a semiconductor material extending along a length of the pillar and associated with an ambipolar channel along the length of the pillar; and a plurality of storage portions, each of the plurality of storage portions associated with a respective memory cell of the memory array and including one or more storage materials positioned between a respective one of the plurality of conductors and a respective portion of the semiconductor material along the length of the pillar.
Aspect 17: The memory device of aspect 16, where a conductivity of the ambipolar channel is above a threshold conductivity in response to activation voltages below a first threshold voltage, below the threshold conductivity in response to activation voltages between the first threshold voltage and a second threshold voltage, and above the threshold conductivity in response to activation voltages above the second threshold voltage.
Aspect 18: The memory device of any of aspects 16 through 17, where the semiconductor material includes a transition metal dichalcogenide material.
Aspect 19: The memory device of any of aspects 16 through 18, where each of the plurality of storage portions includes a ferroelectric material, a charge-trapping material, or a combination thereof.
Aspect 20: The memory device of aspect 19, where each respective memory cell is operable to store a respective logic state based at least in part on a charge stored in a respective portion of the charge-trapping material of the one or more storage materials, on a dipole polarization stored in a respective portion of the ferroelectric material of the one or more storage materials, or both.
Aspect 21: The memory device of any of aspects 16 through 20, where the one or more storage materials are included in a continuous formation of the one or more storage materials around the semiconductor material.
Aspect 22: The memory device of any of aspects 16 through 21, where the semiconductor material is a layer of semiconductor material around a dielectric core of the pillar.
Aspect 23: The memory device of any of aspects 16 through 22, where, for each of the plurality of storage portions, a storage material of the one or more storage materials is in contact with a respective portion of the semiconductor material.
Aspect 24: The memory device of any of aspects 16 through 22, further including: one or more dielectric materials positioned between the plurality of conductors and the plurality of storage portions.
Aspect 25: The memory device of any of aspects 16 through 24, further including: a first select line operable to couple a first end of the pillar with a first access line of the memory array; and a second select line operable to couple a second end of the pillar with a second access line of the memory array.

Information and signals described herein may be represented using any of a variety of different technologies and techniques. For example, data, instructions, commands, information, signals, bits, or symbols of signaling that may be referenced throughout the above description may be represented by voltages, currents, electromagnetic waves, magnetic fields or particles, optical fields or particles, or any combination thereof. Some drawings may illustrate signals as a single signal; however, the signal may represent a bus of signals, where the bus may have a variety of bit widths.

The terms "electronic communication," "conductive contact," "connected," and "coupled" may refer to a relationship between components that supports the flow of signals between the components. Components are considered in electronic communication with (or in conductive contact with or connected with or coupled with) one another if there is any conductive path between the components that can, at any time, support the flow of signals between the components. At any given time, the conductive path between components that are in electronic communication with each other (or in conductive contact with or connected with or coupled with) may be an open circuit or a closed circuit based on the operation of the device that includes the connected components. The conductive path between connected components may be a direct conductive path between the components or the conductive path between connected components may be an indirect conductive path that may include intermediate components, such as switches, transistors, or other components. In some examples, the flow of signals between the connected components may be interrupted for a time, for example, using one or more intermediate components such as switches or transistors.

The term "coupling" (e.g., "electrically coupling") may refer to a condition of moving from an open-circuit relationship between components in which signals are not presently capable of being communicated between the components over a conductive path to a closed-circuit relationship between components in which signals are capable of being communicated between components over the conductive path. If a component, such as a controller, couples other components together, the component initiates a change that allows signals to flow between the other components over a conductive path that previously did not permit signals to flow.

The term "isolated" refers to a relationship between components in which signals are not presently capable of flowing between the components. Components are isolated from each other if there is an open circuit between them. For example, two components separated by a switch that is positioned between the components are isolated from each other if the switch is open. If a controller isolates two components, the controller affects a change that prevents signals from flowing between the components using a conductive path that previously permitted signals to flow.

The term "layer" or "level" used herein refers to a stratum or sheet of a geometrical structure (e.g., relative to a substrate). Each layer or level may have three dimensions (e.g., height, width, and depth) and may cover at least a portion of a surface. For example, a layer or level may be a three dimensional structure where two dimensions are greater than a third, e.g., a thin-film. Layers or levels may include different elements, components, or materials, or combinations thereof. In some examples, one layer or level may be composed of two or more sublayers or sublevels.

Various dielectric materials are described herein. Each dielectric material may include a silicon oxide, silicon nitride, a silicon carbon nitride, a tetraethyl orthosilicate (TEOS), some other dielectric material, or any combination thereof.

The terms "if," "when," "based on," or "based at least in part on" may be used interchangeably. In some examples, if the terms "if," "when," "based on," or "based at least in part on" are used to describe a conditional action, a conditional process, or connection between portions of a process, the terms may be interchangeable.

The term "in response to" may refer to one condition or action occurring at least partially, if not fully, as a result of a previous condition or action. For example, a first condition or action may be performed and second condition or action may at least partially occur as a result of the previous condition or action occurring (whether directly after or after one or more other intermediate conditions or actions occurring after the first condition or action).

Additionally, the terms "directly in response to" or "in direct response to" may refer to one condition or action occurring as a direct result of a previous condition or action. In some examples, a first condition or action may be performed and second condition or action may occur directly as a result of the previous condition or action occurring independent of whether other conditions or actions occur. In some examples, a first condition or action may be performed and second condition or action may occur directly as a result of the previous condition or action occurring, such that no other intermediate conditions or actions occur between the earlier condition or action and the second condition or action or a limited quantity of one or more intermediate steps or actions occur between the earlier condition or action and the second condition or action. Any condition or action described herein as being performed "based on," "based at least in part on," or "in response to" some other step, action, event, or condition may additionally, or alternatively, (e.g., in an alternative example), be performed "in direct response to" or "directly in response to" such other condition or action unless otherwise specified.

The devices discussed herein, including a memory array, may be formed on a semiconductor substrate, such as silicon, germanium, silicon-germanium alloy, gallium arsenide, gallium nitride, etc. In some examples, the substrate is a semiconductor wafer. In some other examples, the substrate may be a silicon-on-insulator (SOI) substrate, such as silicon-on-glass (SOG) or silicon-on-sapphire (SOP), or epitaxial layers of semiconductor materials on another substrate. The conductivity of the substrate, or sub-regions of the substrate, may be controlled through doping using various chemical species including, but not limited to, phosphorus, boron, or arsenic. Doping may be performed during the initial formation or growth of the substrate, by ion-implantation, or by any other doping means.

A switching component or a transistor discussed herein may represent a field-effect transistor (FET) and comprise a three terminal device including a source, drain, and gate. The terminals may be connected to other electronic elements through conductive materials, e.g., metals. The source and drain may be conductive and may comprise a heavily-doped, e.g., degenerate, semiconductor region. The source and drain may be separated by a lightly-doped semiconductor region or channel. If the channel is n-type (i.e., majority carriers are electrons), then the FET may be referred to as an n-type FET. If the channel is p-type (i.e., majority carriers are holes), then the FET may be referred to as a p-type FET. The channel may be capped by an insulating gate oxide. The channel conductivity may be controlled by applying a voltage to the gate. For example, applying a positive voltage or negative voltage to an n-type FET or a p-type FET, respectively, may result in the channel becoming conductive. A transistor may be "on" or "activated" if a voltage greater than or equal to the transistor's threshold voltage is applied to the transistor gate. The transistor may be "off' or "deactivated" if a voltage less than the transistor's threshold voltage is applied to the transistor gate. A transistor implemented with an ambipolar channel may have two threshold voltages, and may be activated if a voltage less than a first threshold voltage or a voltage greater than a second threshold voltage is applied to the transistor gate.

The description set forth herein, in connection with the appended drawings, describes example configurations and does not represent all the examples that may be implemented or that are within the scope of the claims. The term "exemplary" used herein means "serving as an example, instance, or illustration" and not "preferred" or "advantageous over other examples." The detailed description includes specific details to provide an understanding of the described techniques. These techniques, however, may be practiced without these specific details. In some instances, well-known structures and devices are shown in block diagram form to avoid obscuring the concepts of the described examples.

In the appended figures, similar components or features may have the same reference label. Further, various components of the same type may be distinguished by following the reference label by a hyphen and a second label that distinguishes among the similar components. If just the first reference label is used in the specification, the description is applicable to any one of the similar components having the same first reference label irrespective of the second reference label.

The functions described herein may be implemented in hardware, software executed by a processing system (e.g., one or more processors, one or more controllers, control circuitry processing circuitry, logic circuitry), firmware, or any combination thereof. If implemented in software executed by a processing system, the functions may be stored on or transmitted over as one or more instructions (e.g., code) on a computer-readable medium. Due to the nature of software, functions described herein can be implemented using software executed by a processing system, hardware, firmware, hardwiring, or combinations of any of these. Features implementing functions may be physically located at various positions, including being distributed such that portions of functions are implemented at different physical locations.

Illustrative blocks and modules described herein may be implemented or performed with one or more processors, such as a DSP, an ASIC, an FPGA, discrete gate logic, discrete transistor logic, discrete hardware components, other programmable logic device, or any combination thereof designed to perform the functions described herein. A processor may be an example of a microprocessor, a controller, a microcontroller, a state machine, or other types of processors. A processor may also be implemented as at least one of one or more computing devices (e.g., a combination of a DSP and a microprocessor, multiple microprocessors, one or more microprocessors in conjunction with a DSP core, or any other such configuration).

As used herein, including in the claims, "or" as used in a list of items (for example, a list of items prefaced by a phrase such as "at least one of' or "one or more of") indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

As used herein, including in the claims, the article "a" before a noun is openended and understood to refer to "at least one" of those nouns or "one or more" of those nouns. Thus, the terms "a," "at least one," "one or more," "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" or "said" may refer to any or all of the one or more components. For example, referring to "the one or more components" subsequently in the claims may be understood to be equivalent to referring to "at least one of the one or more components."

Computer-readable media includes both non-transitory computer storage media and communication media including any medium that facilitates transfer of a computer program from one place to another. A non-transitory storage medium may be any available medium, or combination of multiple media, which can be accessed by a computer. By way of example, and not limitation, non-transitory computer-readable media can comprise RAM, ROM, electrically erasable programmable read-only memory (EEPROM), optical disk storage, magnetic disk storage or other magnetic storage devices, or any other non-transitory medium or combination of media that can be used to carry or store desired program code means in the form of instructions or data structures and that can be accessed by a computer, or one or more processors.

The description herein is provided to enable a person skilled in the art to make or use the disclosure. Various modifications to the disclosure will be apparent to those skilled in the art, and the generic principles defined herein may be applied to other variations without departing from the scope of the disclosure. Thus, the disclosure is not limited to the examples and designs described herein but is to be accorded the broadest scope consistent with the principles and novel features disclosed herein.

Further embodiments are set out in the following clauses in which:
1. A memory device, comprising:
   a plurality of conductors distributed along a direction from a substrate of the memory device, each of the plurality of conductors associated with a respective one of a plurality of activation lines of a memory array;
   a pillar extending along the direction from the substrate and through the plurality of conductors, the pillar comprising a semiconductor material extending along a length of the pillar and associated with an ambipolar channel along the length of the pillar; and
   a plurality of storage portions, each of the plurality of storage portions associated with a respective memory cell of the memory array and comprising one or more storage materials positioned between a respective one of the plurality of conductors and a respective portion of the semiconductor material along the length of the pillar.
2. The memory device of clause 1, wherein a conductivity of the ambipolar channel is above a threshold conductivity in response to activation voltages below a first threshold voltage, below the threshold conductivity in response to activation voltages between the first threshold voltage and a second threshold voltage, and above the threshold conductivity in response to activation voltages above the second threshold voltage.
3. The memory device of clause 1, wherein the semiconductor material comprises a transition metal dichalcogenide material.
4. The memory device of clause 1, wherein each of the plurality of storage portions comprises a ferroelectric material, a charge-trapping material, or a combination thereof.
5. The memory device of clause 4, wherein each respective memory cell is operable to store a respective logic state based at least in part on a charge stored in a respective portion of the charge-trapping material of the one or more storage materials, on a dipole polarization stored in a respective portion of the ferroelectric material of the one or more storage materials, or a combination thereof.
6. The memory device of clause 1, wherein the one or more storage materials are included in a continuous formation of the one or more storage materials around the semiconductor material.
7. The memory device of clause 1, wherein the semiconductor material is a layer of semiconductor material around a dielectric core of the pillar.
8. The memory device of clause 1, wherein, for each of the plurality of storage portions, a storage material of the one or more storage materials is in contact with a respective portion of the semiconductor material.
9. The memory device of clause 1, further comprising:
   one or more dielectric materials positioned between the plurality of conductors and the plurality of storage portions.
10. The memory device of clause 1, further comprising:
   a first select line operable to couple a first end of the pillar with a first access line of the memory array; and
   a second select line operable to couple a second end of the pillar with a second access line of the memory array.
11. A method for operating a memory device, comprising:
   writing a logic state to a memory cell of a memory array, wherein the writing comprises:
   biasing a pillar with a first voltage, the pillar associated with an ambipolar semiconductor channel extending along a length of the pillar through a plurality of activation lines of the memory array;
   biasing a first activation line of the plurality of activation lines with a second voltage that is less than the first voltage, the first activation line coupled with the memory cell;
   biasing one or more second activation lines of the plurality of activation lines, other than the first activation line, with a third voltage that is different than the first voltage and the second voltage; and
   storing an electric field in one or more storage materials based at least in part on biasing the pillar with the first voltage, biasing the first activation line with the second voltage, and
   biasing the one or more second activation lines with the third voltage, the one or more storage materials being positioned between the first activation line and the ambipolar semiconductor channel.
12. The method of clause 11, wherein:
   biasing the first activation line with the second voltage that is less than the first voltage is configured to activate a first portion of the ambipolar semiconductor channel; and
   biasing the one or more second activation lines with the third voltage that is different than the first voltage and the second voltage is configured to activate one or more second portions of the ambipolar semiconductor channel.
13. The method of clause 11, wherein an absolute difference between the second voltage and the first voltage is greater than an absolute difference between the third voltage and the first voltage.
14. The method of clause 11, wherein the third voltage is between the first voltage and the second voltage.
15. The method of clause 11, wherein biasing the pillar with the first voltage is based at least in part on coupling the pillar with an access line of the memory array that is biased with the first voltage.
16. The method of clause 15, wherein the access line is coupled with a first end of the pillar, the method further comprising:
   isolating a second end of the pillar from a second access line of the memory array while the pillar is coupled with access line.
17. The method of clause 16, further comprising:
   isolating a first end of a second pillar from the access line during the writing, the second pillar associated with a second ambipolar semiconductor channel extending along a length of the second pillar through the plurality of activation lines; and
   isolating a second end of the second pillar from the second access line during the writing.
18. The method of clause 11, further comprising:
   erasing the memory cell, wherein the erasing comprises:
   biasing the pillar with the first voltage;
   biasing the first activation line with a fourth voltage that is greater than the first voltage;
   biasing the one or more second activation lines with a fifth voltage that is different than the first voltage and the fourth voltage; and
   storing a second electric field in the one or more storage materials based at least in part on biasing the pillar with the first voltage, biasing the first activation line with the fourth voltage, and biasing the one or more second activation lines with the fifth voltage.
19. The method of clause 18, wherein:
   biasing the first activation line with the fourth voltage that is greater than the first voltage is configured to activate a first portion of the ambipolar semiconductor channel; and
   biasing the one or more second activation lines with the fifth voltage that is different than the first voltage and the fourth voltage is configured to activate one or more second portions of the ambipolar semiconductor channel.
20. The method of clause 18, wherein an absolute difference between the fourth voltage and the first voltage is greater than an absolute difference between the fifth voltage and the first voltage.
21. The method of clause 18, wherein the fifth voltage is between the first voltage and the fourth voltage.
22. The method of clause 18, wherein the erasing is performed in response to a write command before the writing.
23. The method of clause 11, wherein the one or more storage materials comprise a charge-trapping material, a ferroelectric material, or both.
24. The method of clause 11, wherein storing the electric field comprises storing a charge in a charge-trapping material of the one or more storage materials.
25. The method of clause 11, wherein storing the electric field comprises storing a polarization of a ferroelectric material of the one or more storage materials.
26. A memory device, comprising:
   one or more memory arrays; and
   circuitry coupled with the one or more memory arrays and configured to cause the memory device to:
      write a logic state to a memory cell of a memory array of the one or more memory arrays,
      wherein the writing comprises:
         biasing a pillar with a first voltage, the pillar associated with an ambipolar semiconductor channel extending along a length of the pillar through a plurality of activation lines of the memory array;
         biasing a first activation line of the plurality of activation lines with a second voltage that is less than the first voltage, the first activation line coupled with the memory cell;
         biasing one or more second activation lines of the plurality of activation lines, other than the first activation line, with a third voltage that is different than the first voltage and the second voltage; and
         store an electric field in one or more storage materials based at least in part on biasing the pillar with the first voltage, biasing the first activation line with the second voltage, and
         biasing the one or more second activation lines with the third voltage, the one or more storage materials being positioned between the first activation line and the ambipolar semiconductor channel.
27. The memory device of clause 26, wherein:
   biasing the first activation line with the second voltage that is less than the first voltage is configured to activate a first portion of the ambipolar semiconductor channel, and
   biasing the one or more second activation lines with the third voltage that is different than the first voltage and the second voltage is configured to activate one or more second portions of the ambipolar semiconductor channel.
28. The memory device of clause 26, wherein an absolute difference between the second voltage and the first voltage is greater than an absolute difference between the third voltage and the first voltage.

## Claims

1. A memory device, comprising:
a plurality of conductors distributed along a direction from a substrate of the memory device, each of the plurality of conductors associated with a respective one of a plurality of activation lines of a memory array;
a pillar extending along the direction from the substrate and through the plurality of conductors, the pillar comprising a semiconductor material extending along a length of the pillar and associated with an ambipolar channel along the length of the pillar; and
a plurality of storage portions, each of the plurality of storage portions associated with a respective memory cell of the memory array and comprising one or more storage materials positioned between a respective one of the plurality of conductors and a respective portion of the semiconductor material along the length of the pillar.

2. The memory device of claim 1, wherein a conductivity of the ambipolar channel is above a threshold conductivity in response to activation voltages below a first threshold voltage, below the threshold conductivity in response to activation voltages between the first threshold voltage and a second threshold voltage, and above the threshold conductivity in response to activation voltages above the second threshold voltage.

3. The memory device of claim 1, wherein the semiconductor material comprises a transition metal dichalcogenide material.

4. The memory device of claim 1, wherein each of the plurality of storage portions comprises a ferroelectric material, a charge-trapping material, or a combination thereof.

5. The memory device of claim 4, wherein each respective memory cell is operable to store a respective logic state based at least in part on a charge stored in a respective portion of the charge-trapping material of the one or more storage materials, on a dipole polarization stored in a respective portion of the ferroelectric material of the one or more storage materials, or a combination thereof.

6. The memory device of claim 1, wherein the one or more storage materials are included in a continuous formation of the one or more storage materials around the semiconductor material.

7. The memory device of claim 1, wherein the semiconductor material is a layer of semiconductor material around a dielectric core of the pillar.

8. The memory device of claim 1, wherein, for each of the plurality of storage portions, a storage material of the one or more storage materials is in contact with a respective portion of the semiconductor material.

9. The memory device of claim 1, further comprising:
one or more dielectric materials positioned between the plurality of conductors and the plurality of storage portions.

10. The memory device of claim 1, further comprising:
a first select line operable to couple a first end of the pillar with a first access line of the memory array; and
a second select line operable to couple a second end of the pillar with a second access line of the memory array.

11. A method for operating a memory device, comprising:
writing a logic state to a memory cell of a memory array, wherein the writing comprises:
biasing a pillar with a first voltage, the pillar associated with an ambipolar semiconductor channel extending along a length of the pillar through a plurality of activation lines of the memory array;
biasing a first activation line of the plurality of activation lines with a second voltage that is less than the first voltage, the first activation line coupled with the memory cell;
biasing one or more second activation lines of the plurality of activation lines, other than the first activation line, with a third voltage that is different than the first voltage and the second voltage; and
storing an electric field in one or more storage materials based at least in part on biasing the pillar with the first voltage, biasing the first activation line with the second voltage, and biasing the one or more second activation lines with the third voltage, the one or more storage materials being positioned between the first activation line and the ambipolar semiconductor channel.

12. The method of claim 11, wherein:
biasing the first activation line with the second voltage that is less than the first voltage is configured to activate a first portion of the ambipolar semiconductor channel; and
biasing the one or more second activation lines with the third voltage that is different than the first voltage and the second voltage is configured to activate one or more second portions of the ambipolar semiconductor channel.

13. The method of claim 11, wherein an absolute difference between the second voltage and the first voltage is greater than an absolute difference between the third voltage and the first voltage.

14. The method of claim 11, wherein the third voltage is between the first voltage and the second voltage.

15. The method of claim 11, wherein biasing the pillar with the first voltage is based at least in part on coupling the pillar with an access line of the memory array that is biased with the first voltage.
